# EUROPEAN PATENT SPECIFICATION

(11) **EP 4 145 512 B1**
(45) Date of publication and mention of the grant of the patent: **05.11.2025**
(21) Application number: 22191117.5
(22) Date of filing: 19.08.2022
(51) Int. Cl.: H10D 86/40, H10D 86/60, H10D 86/01, H10K 59/131, H10K 77/10

(54) **DISPLAY DEVICE**
ANZEIGEVORRICHTUNG
DISPOSITIF D'AFFICHAGE

(30) Priority: 03.09.2021 KR 20210117763
(43) Date of publication of application: 08.03.2023
(73) Proprietor: LG Display Co., Ltd., SEOUL, 07336 (KR)
(72) Inventor: YOON, DooHyun, 10845 Paju-si (KR); JANG, Hun, 10845 Paju-si (KR); EOM, HyeSeon, 10845 Paju-si (KR)
(74) Representative: Beal, James Michael

(56) References cited:
- CN-A- 112 103 319
- KR-A- 20180 070 185
- KR-A- 20200 062 762
- US-A1- 2019 392 786
- US-A1- 2022 093 896

## Description

### CROSS-REFERENCE TO RELATED APPLICATIONS

This application claims the priority of Korean Patent Application No. 10-2021-0117763 filed on September 03, 2021, in the Korean Intellectual Property Office.

### BACKGROUND

### Field

The present disclosure relates to a display device, and more particularly, to a display device that does not use a plastic substrate, thereby improving moisture transmission properties and reducing parasitic capacitance.

### Description of the Related Art

As display devices used for a monitor of a computer, a TV set, a mobile phone, and the like, there are an organic light-emitting display (OLED) configured to autonomously emit, and a liquid crystal display (LCD) that requires a separate light source.

The range of application of the display devices is diversified from the monitor of the computer and the TV set to personal mobile devices, and studies are being conducted on the display devices having wide display areas and having reduced volumes and weights.

In addition, recently, a flexible display device, which is made by forming display elements, lines, and the like on a substrate made of a flexible plastic material having flexibility and thus may display images even by being folded or rolled up, has attracted attention as a next-generation display device.

CN 112 103 319 A describes a display panel, a display device and a manufacturing method of the display panel. US 2019/0392786 A1 describes a display device whose aspect ratio can be changed.

### SUMMARY

An invention is set out in the independent claim.

An object to be achieved by the present disclosure is to provide a display device that uses a substrate configured as one of a transparent conducting oxide layer and an oxide semiconductor layer, instead of a plastic substrate.

Another object to be achieved by the present disclosure is to provide a display device that minimizes penetration of moisture and oxygen.

Still another object to be achieved by the present disclosure is to provide a display device capable of simplifying a process and reducing manufacturing costs by eliminating a plastic substrate.

Yet another object to be achieved by the present disclosure is to provide a display device capable of minimizing noise by reducing parasitic capacitance applied to a signal line for transmitting an alternating current voltage.

Still another object to be achieved by the present disclosure is to provide a display device capable of stably operating by increasing a capacity of a storage capacitor.

Objects of the present disclosure are not limited to the above-mentioned objects, and other objects, which are not mentioned above, can be clearly understood by those skilled in the art from the following descriptions.

According to an aspect of the present disclosure, a display device includes: a plurality of substrates disposed in a plurality of subpixels and configured one of a transparent conducting oxide layer or an oxide semiconductor layer; a plurality of transistors respectively disposed on the plurality of substrates and provided in the plurality of subpixels, respectively; a plurality of data lines extending in a column direction between the plurality of subpixels and configured to transmit data voltages to the plurality of subpixels; and a plurality of light-emitting elements respectively disposed in the plurality of subpixels and electrically connected to the plurality of transistors, in which the plurality of substrates is disposed to spaced apart from one another, and in which the plurality of data lines is disposed in a region in which the plurality of substrates is spaced apart from one another.

According to another aspect of the present disclosure, a display device includes: a plurality of substrates configured one of a transparent conducting oxide layer or an oxide semiconductor layer and having a pixel area in which a plurality of subpixels is disposed; a plurality of transistors electrically connected to the plurality of subpixels, respectively; a plurality of signal lines extending in a column direction between the plurality of subpixels and configured to transmit alternating current voltages; and a plurality of light-emitting elements respectively disposed in the plurality of subpixels and electrically connected to the plurality of transistors, in which the plurality of substrates is disposed to spaced apart from one another, and in which the plurality of signal lines is disposed in a region in which the plurality of substrates is spaced apart from one another.

Other detailed matters of the exemplary embodiments are included in the detailed description and the drawings.

According to the present disclosure, it is possible to easily control moisture permeability by using the transparent conducting oxide layer or the oxide semiconductor layer as the substrate of the display device.

According to the present disclosure, it is possible to improve flexibility of the display device by using the thin-film transparent conducting oxide layer or the thin-film oxide semiconductor layer as the substrate of the display device.

According to the present disclosure, the thin-film transparent conducting oxide layer or the thin-film oxide semiconductor layer is used as the substrate of the display device. Therefore, it is possible to reduce stress occurring when the display device is bent or rolled up, thereby reducing cracks in the display device.

According to the present disclosure, it is possible to simplify the structure of the display device and reduce the manufacturing costs by using the transparent conducting oxide layer or the oxide semiconductor layer as the substrate of the display device.

According to the present disclosure, it is possible to reduce static electricity occurring on the substrate and improve the display quality by using the transparent conducting oxide layer or the oxide semiconductor layer as the substrate of the display device.

According to the present disclosure, the substrate of the display device may be manufactured by the deposition process in the vacuum environment. Therefore, it is possible to shorten the substrate manufacturing time and reduce particles occurring on the substrate and defects caused by the particles

According to the present disclosure, the substrate of the display device, which is configured as the transparent conducting oxide layer or the oxide semiconductor layer, may be disposed so as not to overlap the signal line for transmitting the alternating current voltage, thereby minimizing the occurrence of parasitic capacitance.

According to the present disclosure, the substrate made of transparent conducting oxide may be used as a capacitor, thereby improving the capacity of the storage capacitor and more stably operating the display device.

The effects according to the present disclosure are not limited to the contents exemplified above, and more various effects are included in the present specification.

### BRIEF DESCRIPTION OF THE DRAWINGS

The above and other aspects, features and other advantages of the present disclosure will be more clearly understood from the following detailed description taken in conjunction with the accompanying drawings, in which:
FIG. 1 is a top plan view of a display device according to an embodiment of the present disclosure;
FIG. 2 is a schematic cross-sectional view of the display device according to the embodiment of the present disclosure;
FIG. 3 is a circuit diagram of a subpixel of the display device according to the embodiment of the present disclosure;
FIG. 4A is an enlarged top plan view of the display device according to the embodiment of the present disclosure;
FIG. 4B is an enlarged top plan view of a plurality of substrates in FIG. 4A;
FIG. 5 is a cross-sectional view taken along line V-V' in FIG. 4;
FIG. 6 is a cross-sectional view of a display device according to another embodiment of the present disclosure;
FIG. 7A is an enlarged top plan view of a display device according to still another embodiment of the present disclosure;
FIG. 7B is an enlarged top plan view of a plurality of substrates in FIG. 7A;
FIG. 8 is a cross-sectional view of a display device according to yet another embodiment of the present disclosure;
FIG. 9A is an enlarged top plan view of a display device according to still yet another embodiment of the present disclosure;
FIG. 9B is an enlarged top plan view of a plurality of substrates in FIG. 9A; and
FIG. 10 is a cross-sectional view of a display device according to a further embodiment of the present disclosure.

### DETAILED DESCRIPTION OF THE EMBODIMENT

Advantages and characteristics of the present disclosure and a method of achieving the advantages and characteristics will be clear by referring to exemplary embodiments described below in detail together with the accompanying drawings. However, the present disclosure is not limited to the exemplary embodiments disclosed herein but will be implemented in various forms. The exemplary embodiments are provided by way of example only so that those skilled in the art can fully understand the disclosures of the present disclosure and the scope of the present disclosure. Therefore, the present disclosure will be defined only by the scope of the appended claims.

The shapes, sizes, ratios, angles, numbers, and the like illustrated in the accompanying drawings for describing the exemplary embodiments of the present disclosure are merely examples, and the present disclosure is not limited thereto. Like reference numerals generally denote like elements throughout the specification. Further, in the following description of the present disclosure, a detailed explanation of known related technologies may be omitted to avoid unnecessarily obscuring the subject matter of the present disclosure. The terms such as "including," "having," and "consist of' used herein are generally intended to allow other components to be added unless the terms are used with the term "only". Any references to singular may include plural unless expressly stated otherwise.

Components are interpreted to include an ordinary error range even if not expressly stated.

When the position relation between two parts is described using the terms such as "on", "above", "below", and "next", one or more parts may be positioned between the two parts unless the terms are used with the term "immediately" or "directly".

When an element or layer is disposed "on" another element or layer, another layer or another element may be interposed directly on the other element or therebetween.

Although the terms "first", "second", and the like are used for describing various components, these components are not confined by these terms. These terms are merely used for distinguishing one component from the other components. Therefore, a first component to be mentioned below may be a second component in a technical concept of the present disclosure.

Like reference numerals generally denote like elements throughout the specification.

A size and a thickness of each component illustrated in the drawing are illustrated for convenience of description, and the present disclosure is not limited to the size and the thickness of the component illustrated.

The features of various embodiments of the present disclosure can be partially or entirely adhered to or combined with each other and can be interlocked and operated in technically various ways, and the embodiments can be carried out independently of or in association with each other.

Hereinafter, a stretchable display device according to exemplary embodiments of the present disclosure will be described in detail with reference to accompanying drawings.

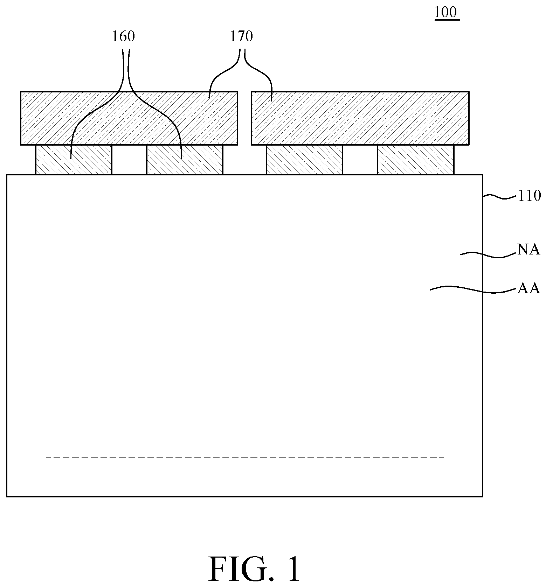

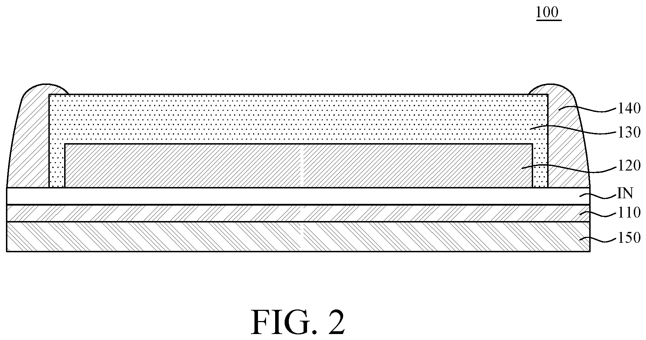

FIG. 1 is a top plan view of a display device according to an embodiment of the present disclosure. FIG. 2 is a schematic cross-sectional view of the display device according to the embodiment of the present disclosure. For the convenience of description, FIG. 1 illustrates only a substrate 110, a plurality of flexible films 160, and a plurality of printed circuit boards 170 among various constituent elements of a display device 100.

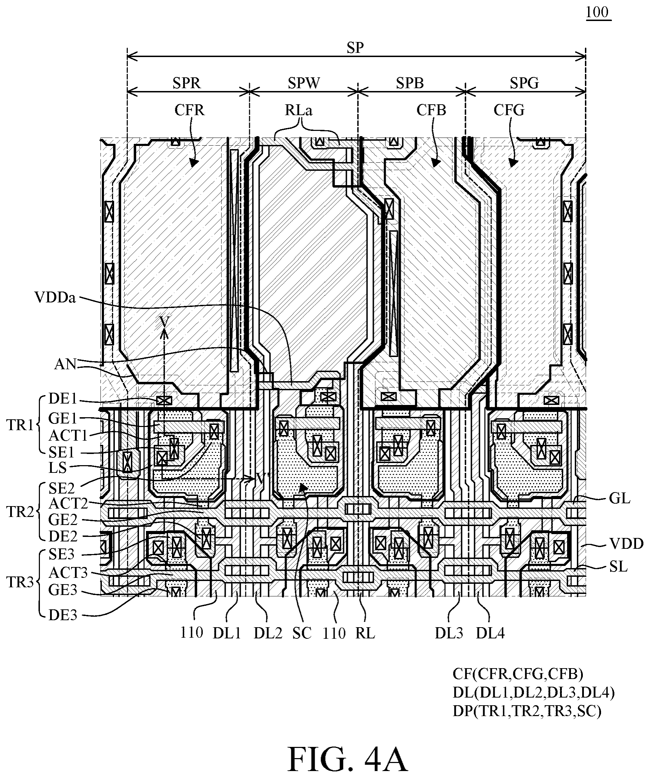

Referring to FIGS. 1 and 2, the substrate 110 is a support member for supporting the other constituent elements of the display device 100. FIGS. 1 and 2 illustrate that the substrate 110 has a single pattern, for the convenience of description. The substrate 110 is provided in plural. That is, the plurality of substrates 110, which is spaced apart from one another, may be disposed to support the other constituent elements of the display device 100. The plurality of substrates 110 will be described in more detail with reference to FIGS. 4A to 5.

The substrate 110 may be made of any one of a transparent conducting oxide and an oxide semiconductor. For example, the substrate 110 may be made of transparent conducting oxide (TCO) such as indium tin oxide (ITO), indium zinc oxide (IZO), and indium-tin-zinc oxide (ITZO).

In addition, the substrate 110 may be made of an oxide semiconductor material containing indium (In) and gallium (Ga), for example, a transparent oxide semiconductor such as indium-gallium-zinc oxide (IGZO), indium gallium oxide (IGO), and indium-tin-zinc oxide (ITZO). However, the materials and types of transparent conducting oxide and oxide semiconductors are exemplarily provided. The substrate 110 may be made of other transparent conducting oxide and oxide semiconductor materials that are not disclosed in the present specification. However, the present disclosure is not limited thereto.

Meanwhile, the substrate 110 may be formed by depositing the transparent conducting oxide or oxide semiconductor with a very small thickness. Therefore, the substrate 110 may have flexibility as the substrate 110 has a very small thickness. Further, the display device 100 including the substrate 110 having flexibility may be implemented as the flexible display device 100 that may display images even though the display device 100 is folded or rolled up. For example, in a case in which the display device 100 is a foldable display device, the substrate 110 may be folded or unfolded about a folding axis. As another example, in a case in which the display device 100 is a rollable display device, the display device may be rolled up around a roller and stored. Therefore, the display device 100 according to the embodiment of the present disclosure may be implemented as the flexible display device 100 such as a foldable display device or a rollable display device by using the substrate 110 having flexibility.

In addition, the display device 100 according to the embodiment of the present disclosure may perform a laser-lift-off (LLO) process by using the substrate 110 made of the transparent conducting oxide or oxide semiconductor. The LLO process means a process of separating a temporary substrate, which is disposed below the substrate 110, from the substrate 110 by using a laser during a process of manufacturing the display device 100. Therefore, the substrate 110 is a layer for further facilitating the LLO process, and thus the substrate 110 may be called a functional thin-film, a functional thin-film layer, or a functional substrate. The LLO process will be described below in more detail.

The substrate 110 includes a display area AA and a non-display area NA.

The display area AA is a region in which images are displayed. To display the image, a pixel part 120 including a plurality of subpixels may be disposed in the display area AA. For example, the pixel part 120 may include the plurality of subpixels including light-emitting elements and drive circuits, thereby displaying the image.

The non-display area NA is a region in which no image is displayed. Various lines, drive ICs, and the like for operating the subpixels disposed in the display area AA are disposed. For example, various drive ICs such as a gate driver IC and a data driver IC may be disposed in the non-display area NA.

The plurality of flexible films 160 is disposed at one end of the substrate 110. The plurality of flexible films 160 is electrically connected to the one end of the substrate 110. The plurality of flexible films 160 each are a film having various types of components disposed on a base film having ductility in order to supply signals to the plurality of subpixels in the display area AA. The plurality of flexible films 160 may each have one end disposed in the non-display area NA of the substrate 110 and supply data voltage or the like to the plurality of subpixels in the display area AA. Meanwhile, FIG. 1 illustrates four flexible films 160. However, the number of flexible films 160 may be variously changed in accordance with design. However, the present disclosure is not limited thereto.

Meanwhile, drive ICs such as gate driver ICs and data driver ICs may be disposed on the plurality of flexible films 160. The drive IC is a component configured to process data for displaying the image and process a driving signal for processing the data. The drive IC may be disposed in ways such as a chip-on-glass (COG) method, a chip-on-film (COF) method, and a tape carrier package (TCP) method depending on how the drive IC is mounted. In the present specification, for the convenience of description, the configuration has been described in which the drive ICs are mounted on the plurality of flexible films 160 by the chip-on-film method. However, the present disclosure is not limited thereto.

The printed circuit boards 170 are connected to the plurality of flexible films 160. The printed circuit board 170 is a component for supplying a signal to the drive IC. Various types of components for supplying the drive IC with various driving signals such as driving signals, data voltages, and the like may be disposed on the printed circuit board 170. Meanwhile, FIG. 1 illustrates two printed circuit boards 170. However, the number of printed circuit boards 170 may be variously changed in accordance with design. The present disclosure is not limited thereto.

Referring to FIG. 2, an insulating layer IN is disposed on the substrate 110. The insulating layer IN may inhibit moisture and/or oxygen penetrating from the outside of the substrate 110 from being diffused. Moisture transmission properties of the display device 100 may be controlled by controlling a thickness or a layered structure of the insulating layer IN. In addition, the insulating layer IN inhibits the substrate 110 made of the transparent conducting oxide or oxide semiconductor from being short-circuited while coming into contact with other components such as the pixel part 120. The insulating layer IN may be made of an inorganic material, for example, configured as a single layer or a multilayer made of silicon oxide (SiOx) or silicon nitride (SiNx). However, the present disclosure is not limited thereto.

The pixel part 120 is disposed on the insulating layer IN. The pixel part 120 may be disposed to correspond to the display area AA. The pixel part 120 includes the plurality of subpixels and is configured to display an image. The plurality of subpixels of the pixel part 120 are minimum units constituting the display area AA. The light-emitting element and the drive circuit may be disposed in each of the plurality of subpixels. For example, the light-emitting element of each of the plurality of subpixels may be an organic light-emitting element including an anode, an organic light-emitting layer, and a cathode or be an LED including N-type and P-type semiconductor layers and a light-emitting layer. However, the present disclosure is not limited thereto. Further, the drive circuit for operating the plurality of subpixels may include driving elements such as a thin-film transistor and a storage capacitor. However, the present disclosure is not limited thereto. Hereinafter, for the convenience of description, the assumption is made that the light-emitting element of each of the plurality of subpixels is the organic light-emitting element. However, the present disclosure is not limited thereto.

Meanwhile, the display device 100 may be a top-emission type display device or a bottom-emission type display device depending on a direction in which light is emitted from the light-emitting element.

The top-emission type display device allows the light emitted from the light-emitting element to propagate toward an upper side of the substrate 110 on which the light-emitting element is disposed. The top-emission type display device may have a reflective layer formed on a lower portion of the anode in order to allow the light emitted from the light-emitting element to propagate toward the upper side of the substrate 110, i.e., toward the cathode.

The bottom-emission type display device allows the light emitted from the light-emitting element to propagate toward a lower side of the substrate 110 on which the light-emitting element is disposed. In the case of the bottom-emission type display device, the anode may be made of only a transparent electrically conductive material and the cathode may be made of a metallic material with high reflectance in order to allow the light emitted from the light-emitting element to propagate toward the lower side of the substrate 110.

Hereinafter, for the convenience of description, the display device 100 according to the embodiment of the present disclosure will be described as being the bottom-emission type display device. However, the present disclosure is not limited thereto.

A sealing layer 130 is disposed to cover the pixel part 120. The sealing layer 130 may seal the pixel part 120 and protect the light-emitting element of the pixel part 120 from outside moisture, oxygen, impact, and the like. The sealing layer 130 may be formed by alternately stacking a plurality of inorganic material layers and a plurality of organic material layers. For example, the inorganic material layer may be made of an inorganic material such as silicon nitride (SiNx), silicon oxide (SiOx), or aluminum oxide (AlOx). The organic material layer may be made of epoxy-based polymer or acrylic polymer. However, the present disclosure is not limited thereto. In addition, the sealing layer 130 may be configured as a face seal type sealing layer. For example, the sealing layer 130 may be formed by applying an ultraviolet-curable or thermosetting sealant onto the entire surface of the pixel part 120. However, the sealing layer 130 may have various structures and be made of various materials. However, the present disclosure is not limited thereto.

In addition, a sealing substrate may be further disposed on the sealing layer 130. The sealing substrate may be made of a metallic material having a high modulus and high corrosion resistance. For example, the sealing substrate may be made of a material having a modulus as high as about 200 to 900 Mpa. The sealing substrate may be made of a metallic material such as aluminum (Al), nickel (Ni), chromium (Cr), iron (Fe), and an alloy of nickel which is easily machined in the form of a foil or thin-film and has high corrosion resistance. Therefore, since the sealing substrate is made of a metallic material, the sealing substrate may be implemented in the form of an ultrathin-film and have protection characteristics strong against outside impact and scratches.

A seal member 140 is disposed to surround side surfaces of the pixel part 120 and the sealing layer 130. The seal member 140 may be disposed in the non-display area NA and disposed to surround the pixel part 120 disposed in the display area AA. The seal member 140 may be disposed to surround the side surface of the pixel part 120 and the side surface of the sealing layer 130, thereby minimizing the penetration of moisture into the pixel part 120. For example, the seal member 140 may be disposed to cover a part of a top surface of the insulating layer IN that overlaps the non-display area NA protruding to the outside of the pixel part 120. The seal member 140 may be disposed to cover a part of the side surface of the sealing layer 130 disposed to surround the pixel part 120. The seal member 140 may be disposed to cover a part of a top surface of the sealing layer 130.

The seal member 140 may be made of an electrically non-conductive material having elasticity in order to seal the side surface of the pixel part 120 and increase rigidity of the side surface of the display device 100. In addition, the seal member 140 may be made of a material having bondability. Further, the seal member 140 may further include a moisture absorbent to absorb moisture and oxygen from the outside and minimize the penetration of moisture through a lateral portion of the display device 100. For example, the seal member 140 may be made of a material such as polyimide (PI), polyurethane, epoxy, or acrylic. However, the present disclosure is not limited thereto.

A polarizing plate 150 is disposed below the substrate 110. The polarizing plate 150 may selectively transmit light and reduce the reflection of external light entering the substrate 110. Specifically, the display device 100 has various metallic materials formed on the substrate 110 and applied to a semiconductor element, a line, and a light-emitting element. Therefore, the external light entering the substrate 110 may be reflected by the metallic material. The reflection of external light may decrease visibility of the display device 100. In this case, the polarizing plate 150 for suppressing the reflection of external light may be disposed below the substrate 110, thereby improving outdoor visibility of the display device 100. However, the polarizing plate 150 may be eliminated in accordance with the implementation of the display device 100.

Meanwhile, although not illustrated in the drawings, a barrier film, together with the polarizing plate 150, may be disposed below the substrate 110. The barrier film may minimize the penetration of moisture and oxygen present outside the substrate 110 into the substrate 110, thereby protecting the pixel part 120 including the light-emitting element. However, the barrier film may be eliminated in accordance with the implementation of the display device 100. However, the present disclosure is not limited thereto.

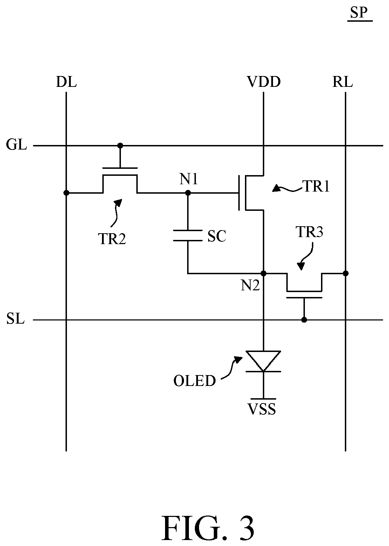

Hereinafter, the plurality of subpixels of the pixel part 120 will be described in more detail with reference to FIGS. 3 to 5.

FIG. 3 is a circuit diagram of a subpixel of the display device according to the embodiment of the present disclosure.

Referring to FIG. 3, the drive circuit for operating the light-emitting element OLED of each of the plurality of subpixels SP includes a first transistor TR1, a second transistor TR2, a third transistor TR3, and a storage capacitor SC. Further, a plurality of lines is disposed on the substrate 110 in order to operate the drive circuit and includes a gate line GL, a data line DL, a high-potential power line VDD, a sensing line SL, and a reference line RL.

The first transistor TR1, the second transistor TR2, and the third transistor TR3, which are included in the drive circuit of the single subpixel SP, each include a gate electrode, a source electrode, and a drain electrode.

Further, the first transistor TR1, the second transistor TR2, and the third transistor TR3 may each be a P-type thin-film transistor or an N-type thin-film transistor. For example, in the P-type thin-film transistor, positive holes flow from the source electrode to the drain electrode, such that current may flow from the source electrode to the drain electrode. In the N-type thin-film transistor, electrons flow from the source electrode to the drain electrode, such that current may flow from the drain electrode to the source electrode. Hereinafter, the assumption is made that the first transistor TR1, the second transistor TR2, and the third transistor TR3 may each be the N-type thin-film transistor in which current flows from the drain electrode to the source electrode. However, the present disclosure is not limited thereto.

The first transistor TR1 includes a first active layer, a first gate electrode, a first source electrode, and a first drain electrode. The first gate electrode is connected to a first node N1. The first source electrode is connected to the anode of the light-emitting element OLED. The first drain electrode is connected to the high-potential power line VDD. The first transistor TR1 may be turned on when a voltage of the first node N1 is higher than a threshold voltage. The first transistor TR1 may be turned off when the voltage of the first node N1 is lower than the threshold voltage. Further, when the first transistor TR1 is turned on, drive current may be transmitted to the light-emitting element OLED through the first transistor TR1. Therefore, the first transistor TR1 configured to control the drive current to be supplied to the light-emitting element OLED may be called a driving transistor.

The second transistor TR2 includes a second active layer, a second gate electrode, a second source electrode, and a second drain electrode. The second gate electrode is connected to the gate line GL. The second source electrode is connected to the first node N1. The second drain electrode is connected to the data line DL. The second transistor TR2 may be turned on or off on the basis of a gate voltage from the gate line GL. When the second transistor TR2 is turned on, the first node N1 may be charged with the data voltage from the data line DL. Therefore, the second transistor TR2 configured to be turned on or off by the gate line GL may be called a switching transistor.

The third transistor TR3 includes a third active layer, a third gate electrode, a third source electrode, and a third drain electrode. The third gate electrode is connected to the sensing line SL. The third source electrode is connected to a second node N2. The third drain electrode is connected to the reference line RL. The third transistor TR3 may be turned on or off on the basis of a sensing voltage from the sensing line SL. Further, when the third transistor TR3 is turned on, a reference voltage may be transmitted from the reference line RL to the second node N2 and the storage capacitor SC. Therefore, the third transistor TR3 may be called a sensing transistor.

Meanwhile, FIG. 3 illustrates that the gate line GL and the sensing line SL are separate lines. However, the gate line GL and the sensing line SL may be implemented as a single line. However, the present disclosure is not limited thereto.

The storage capacitor SC is connected between the first gate electrode and the first source electrode of the first transistor TR1. That is, the storage capacitor SC may be connected between the first node N1 and the second node N2. The storage capacitor SC may supply a predetermined drive current to the light-emitting element OLED by maintaining a potential difference between the first gate electrode and the first source electrode of the first transistor TR1 while the light-emitting element OLED emits light. The storage capacitor SC includes a plurality of capacitor electrodes. For example, one of the plurality of capacitor electrodes may be connected to the first node N1, and another capacitor electrode may be connected to the second node N2.

The light-emitting element OLED includes the anode, the light-emitting layer, and the cathode. The anode of the light-emitting element OLED is connected to the second node N2, and the cathode is connected to the low-potential power line VSS. The light-emitting element OLED may emit light by receiving the drive current from the first transistor TR1.

Meanwhile, FIG. 3 illustrates that the drive circuit of the subpixel SP of the display device 100 according to the embodiment of the present disclosure has a 3T1C structure including the three transistors and the single storage capacitor SC. However, the number of transistors, the number of storage capacitors SC, and a connection relationship between the transistor and the storage capacitor may be variously changed in accordance with design. The present disclosure is not limited thereto.

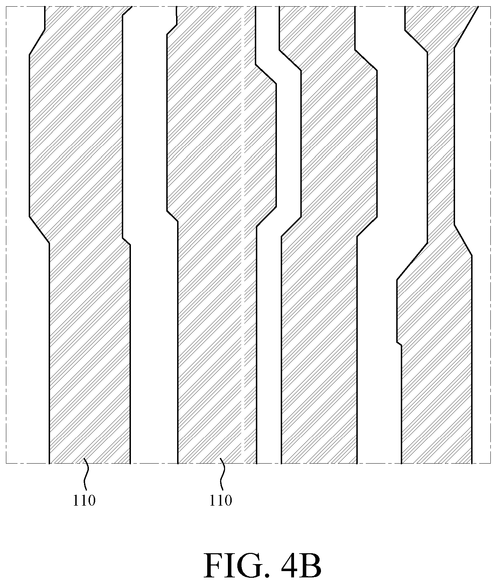

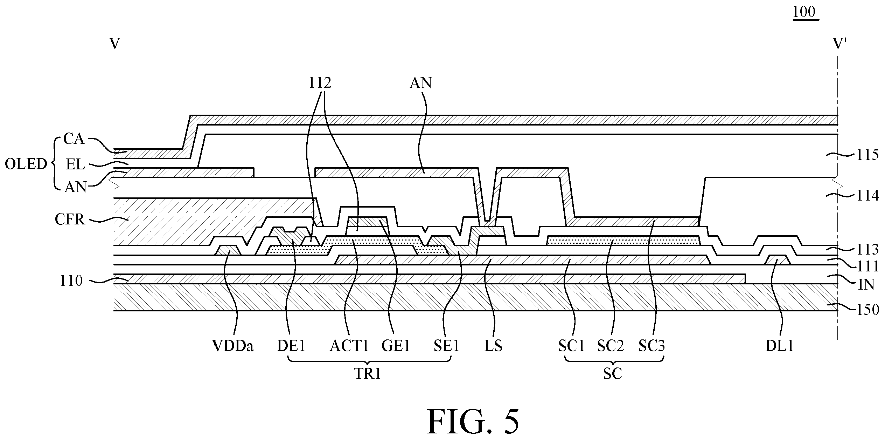

FIG. 4A is an enlarged top plan view of the display device according to the embodiment of the present disclosure. FIG. 4B is an enlarged top plan view of the plurality of substrates in FIG. 4A. FIG. 5 is a cross-sectional view taken along line V-V' in FIG. 4A. FIG. 4A is an enlarged top plan view of a red subpixel SPR, a white subpixel SPW, a blue subpixel SPB, and a green subpixel SPG that constitute the single pixel. For the convenience of description, a bank 115 is not illustrated in FIG. 4A. For the convenience of description, FIG. 4B illustrates only the plurality of substrates 110 among the various constituent elements of the display device 100.

Referring to FIGS. 4A to 5, the display device 100 according to the embodiment of the present disclosure includes the plurality of substrates 110, the insulating layer IN, a buffer layer 111, a gate insulating layer 112, a passivation layer 113, a planarization layer 114, the bank 115, the first transistor TR1, the second transistor TR2, the third transistor TR3, the storage capacitor SC, the light-emitting element OLED, the gate line GL, the sensing line SL, the data line DL, the reference line RL, the high-potential power line VDD, and a plurality of color filters CF.

Referring to FIGS. 4A to 5, the plurality of substrates 110 may extend in a column direction and be disposed to be spaced apart from one another. In this case, the plurality of substrates may be disposed so as not to overlap signal lines such as the data line DL and the reference line RL that transmit alternating current voltages. That is, the data line DL and the reference line RL may be disposed in regions in which the plurality of substrates 110 is spaced apart from one another. Therefore, the plurality of substrates 110 may be disposed so as not to overlap the data line DL and the reference line RL. For example, the plurality of substrates 110 may each have a rim corresponding to extension shapes of the data line DL and the reference line RL so that the plurality of substrates 110 does not overlap the data line DL and the reference line RL disposed between the plurality of substrates 110. However, the shapes of the plurality of substrates 110 are not limited thereto. In other words, lines (e.g. data lines DL and/or reference lines RL) may be disposed between substrates of the plurality of substrates, i.e. in spaces between substrates of the plurality of substrates. It will be appreciated that the plurality of substrates extending in the column direction should not be taken as limiting the display device to any particular orientation, but rather that the label 'column direction' is used for ease of reference in interpreting the figures. The plurality of substrates may extend in a row direction or any other direction. The plurality of substrates may extend in a linear or substantially linear direction.

Referring to FIG. 4A, the plurality of subpixels SP is disposed on the plurality of substrates 110.

The plurality of subpixels SP includes the red subpixel SPR, the green subpixel SPG, the blue subpixel SPB, and the white subpixel SPW. For example, the red subpixel SPR, the white subpixel SPW, the blue subpixel SPB, and the green subpixel SPG may be sequentially disposed in a row direction. However, the arrangement order of the plurality of subpixels SP is not limited thereto.

The plurality of subpixels SP each include a light-emitting area and a circuit area. The light-emitting area is an area that may independently emit light with a single type of color. The light-emitting element OLED may be disposed in the light-emitting area. Specifically, the light-emitting area may be defined as an area exposed from the bank 115 and configured such that the light emitted from the light-emitting element OLED may propagate to the outside among the areas in which the plurality of color filters CF and the anode AN overlap one another. For example, referring to FIGS. 4A and 5 together, the light-emitting area of the red subpixel SPR may be an area exposed from the bank 115 in an area in which a red color filter CFR and the anode AN overlap each other. The light-emitting area of the green subpixel SPG may be an area exposed from the bank 115 in an area in which a green color filter CFG and the anode AN overlap each other. The light-emitting area of the blue subpixel SPB may be a blue light-emitting area that emits blue light in an area exposed from the bank 115 in an area in which a blue color filter CF and the anode AN overlap each other. In this case, the light-emitting area of the white subpixel SPW in which no separate color filter CF is disposed may be a white light-emitting area that emits white light in an area that overlaps a part of the anode AN exposed from the bank 115.

The circuit area is an area except for the light-emitting area. A plurality of lines may be disposed in the circuit area and transmit various types of signals to a drive circuit DP and a drive circuit DP for operating the plurality of light-emitting elements OLED. Further, the circuit area in which the drive circuit DP, the plurality of lines, and the bank 115 are disposed may be a non-light-emitting area. For example, in the circuit area, there may be disposed the drive circuit DP including the first transistor TR1, the second transistor TR2, the third transistor TR3, and the storage capacitor SC, the plurality of high-potential power lines VDD, the plurality of data lines DL, the plurality of reference lines RL, the plurality of gate lines GL, the sensing line SL, and the bank 115. Each substrate of the plurality of substrates may have multiple respective transistors disposed thereon. Each subpixel of the plurality of subpixels may have multiple respective transistors provided therein. In other words, the plurality of transistors may comprise multiple transistors for each substrate and subpixel pairing.

Referring to FIGS. 3 to 5 together, the insulating layer IN is disposed on the plurality of substrates 110. The plurality of high-potential power lines VDD, the plurality of data lines DL, the plurality of reference lines RL, and a light-blocking layer LS are disposed on the insulating layer IN.

The plurality of high-potential power lines VDD, the plurality of data lines DL, the plurality of reference lines RL, and the light-blocking layer LS may be disposed on the same layer on the plurality of substrates 110 and made of the same electrically conductive material. For example, the plurality of high-potential power lines VDD, the plurality of data lines DL, the plurality of reference lines RL, and the light-blocking layer LS may each made of an electrically conductive material such as copper (Cu), aluminum (Al), molybdenum (Mo), nickel (Ni), titanium (Ti), chromium (Cr), or an alloy thereof. However, the present disclosure is not limited thereto.

The plurality of high-potential power lines VDD are lines for transmitting high power voltages to the plurality of subpixels SP. The plurality of high-potential power lines VDD may extend in the column direction between the plurality of subpixels SP. The two subpixels SP adjacent to each other in the row direction may share a single high-potential power line VDD among the plurality of high-potential power lines VDD. For example, one high-potential power line VDD may be disposed at the left side of the red subpixel SPR and supply the high-potential power voltage to the first transistor TR1 of each of the red subpixel SPR and the white subpixel SPW. The other high-potential power line VDD may be disposed at the right side of the green subpixel SPG and supply the high-potential power voltage to the first transistor TR1 of each of the blue subpixel SPB and the green subpixel SPG.

The plurality of data lines DL includes a first data line DL1, a second data line DL2, a third data line DL3 and a fourth data line DL4 which are lines that extend in the column direction between the plurality of subpixels SP and transmit the data voltages to the plurality of subpixels SP. The first data line DL1 may be disposed between the red subpixel SPR and the white subpixel SPW and transmit the data voltage to the second transistor TR2 of the red subpixel SPR. The second data line DL2 may be disposed between the first data line DL1 and the white subpixel SPW and transmit the data voltage to the second transistor TR2 of the white subpixel SPW. The third data line DL3 may be disposed between the blue subpixel SPB and the green subpixel SPG and transmit the data voltage to the second transistor TR2 of the blue subpixel SPB. The fourth data line DL4 may be disposed between the third data line DL3 and the green subpixel SPG and transmit the data voltage to the second transistor TR2 of the green subpixel SPG. In this case, the data line DL may be a signal line for transmitting the alternating current voltage. Therefore, a signal transmitted to the data line DL may have a swing shape.

The plurality of reference lines RL are lines that extend in the column direction between the plurality of subpixels SP and transmit the reference voltage to the plurality of subpixels SP. The plurality of subpixels SP, which constitutes a single pixel, may share the single reference line RL. For example, one reference line RL may be disposed between the white subpixel SPW and the blue subpixel SPB and transmit the reference voltage to the third transistor TR3 of each of the red subpixel SPR, the white subpixel SPW, the blue subpixel SPB, and the green subpixel SPG. In this case, the reference line RL may be a signal line for transmitting the alternating current voltage. Therefore, a signal transmitted to the reference line RL may have a swing shape.

Referring to FIGS. 4A and 5 together, the light-blocking layer LS is disposed on the insulating layer IN. The light-blocking layer LS may be disposed to overlap a first active layer ACT1 of at least the first transistor TR1 among the plurality of transistors TR1, TR2, and TR3 and inhibit the light from entering the first active layer ACT1. If the light is emitted to the first active layer ACT1, a leakage current occurs, which may degrade the reliability of the first transistor TR1 that is a driving transistor. In this case, when the light-blocking layer LS made of an opaque electrically conductive material such as copper (Cu), aluminum (Al), molybdenum (Mo), nickel (Ni), titanium (Ti), chromium (Cr), or an alloy thereof is disposed to overlap the first active layer ACT1, the light-blocking layer LS may inhibit the light from entering the first active layer ACT1 from the lower side of the substrate 110, thereby improving the reliability of the first transistor TR1. However, the present disclosure is not limited thereto. The light-blocking layer LS may be disposed to overlap a second active layer ACT2 of the second transistor TR2 and a third active layer ACT3 of the third transistor TR3.

Meanwhile, the drawings illustrate that the light-blocking layer LS is a single layer. However, the light-blocking layer LS may be provided as a plurality of layers. For example, the light-blocking layer LS may be provided as a plurality of layers disposed to overlap one another with at least any one of the insulating layer IN, the buffer layer 111, the gate insulating layer 112, and the passivation layer 113 interposed therebetween.

The buffer layer 111 is disposed on the plurality of high-potential power lines VDD, the plurality of data lines DL, the plurality of reference lines RL, and the light-blocking layer LS. The buffer layer 111 may suppress the penetration of moisture or impurities through the substrate 110. For example, the buffer layer 111 may be configured as a single layer or multilayer made of silicon oxide (SiOx) or silicon nitride (SiNx). However, the present disclosure is not limited thereto. In addition, the buffer layer 111 may be eliminated in accordance with the type of substrate 110 or the type of transistor, but the present specification is not limited thereto.

The first transistor TR1, the second transistor TR2, the third transistor TR3, and the storage capacitor SC are disposed on the buffer layer 111 of each of the plurality of subpixels SP.

First, the first transistor TR1 includes the first active layer ACT1, a first gate electrode GE1, a first source electrode SE1, and a first drain electrode DE1.

The first active layer ACT1 is disposed on the buffer layer 111. The first active layer ACT1 may be made of a semiconductor material such as an oxide semiconductor, amorphous silicon, or polysilicon, but the present disclosure is not limited thereto. For example, in the case in which the first active layer ACT1 is made of an oxide semiconductor, the first active layer ACT1 may include a channel area, a source area, and a drain area. The source area and the drain area may be areas having conductivity. However, the present disclosure is not limited thereto.

The gate insulating layer 112 is disposed on the first active layer ACT1. The gate insulating layer 112 may be a layer for insulating the first gate electrode GE1 and the first active layer ACT1 and made of an insulating material. For example, the gate insulating layer 112 may be configured as a single layer or multilayer made of silicon oxide (SiOx) or silicon nitride (SiNx), but the present disclosure is not limited thereto.

The first gate electrode GE1 is disposed on the gate insulating layer 112 so as to overlap the first active layer ACT1. The first gate electrode GE1 may be made of an electrically conductive material, for example, copper (Cu), aluminum (Al), molybdenum (Mo), nickel (Ni), titanium (Ti), chromium (Cr), or an alloy thereof. However, the present disclosure is not limited thereto.

The first source electrode SE1 and the first drain electrode DE1 are disposed on the gate insulating layer 112 and spaced apart from each other. The first source electrode SE1 and the first drain electrode DE1 may be electrically connected to the first active layer ACT1 through a contact hole formed in the gate insulating layer 112. The first source electrode SE1 and the first drain electrode DE1 may be disposed on the same layer and made of the same electrically conductive material as the first gate electrode GE1. However, the present disclosure is not limited thereto. For example, the first source electrode SE1 and the first drain electrode DE1 may be made of copper (Cu), aluminum (Al), molybdenum (Mo), nickel (Ni), titanium (Ti), chromium (Cr), or an alloy thereof. However, the present disclosure is not limited thereto.

The first drain electrode DE1 is electrically connected to the high-potential power line VDD. For example, the first drain electrodes DE1 of the red subpixel SPR and the white subpixel SPW may be electrically connected to the high-potential power line VDD at the left side of the red subpixel SPR. The first drain electrodes DE1 of the blue subpixel SPB and the green subpixel SPG may be electrically connected to the high-potential power line VDD at the right side of the green subpixel SPG.

In this case, to electrically connect the first drain electrode DE1 to the high-potential power line VDD, an auxiliary high-potential power line VDDa may be further disposed. The auxiliary high-potential power line VDDa has one end electrically connected to the high-potential power line VDD, and the other end electrically connected to the first drain electrode DE1 of each of the plurality of subpixels SP. For example, in a case in which the auxiliary high-potential power line VDDa is disposed on the same layer and made of the same material as the first drain electrode DE1, one end of the auxiliary high-potential power line VDDa may be electrically connected to the high-potential power line VDD through the contact hole formed in the gate insulating layer 112 and the buffer layer 111, and the other end of the auxiliary high-potential power line VDDa may extend to the first drain electrode DE1 and be integrated with the first drain electrode DE1.

In this case, the first drain electrode DE1 of the red subpixel SPR and the first drain electrode DE1 of the white subpixel SPW, which are electrically connected to the same high-potential power line VDD, may be connected to the same auxiliary high-potential power line VDDa. The first drain electrode DE1 of the blue subpixel SPB and the first drain electrode DE1 of the green subpixel SPG may also be connected to the same auxiliary high-potential power line VDDa. However, the first drain electrode DE1 and the high-potential power line VDD may be electrically connected by means of other methods. However, the present disclosure is not limited thereto.

The first source electrode SE1 may be electrically connected to the light-blocking layer LS through the contact hole formed in the gate insulating layer 112 and the buffer layer 111. In addition, a part of the first active layer ACT1 connected to the first source electrode SE1 may be electrically connected to the light-blocking layer LS through the contact hole formed in the buffer layer 111. If the light-blocking layer LS floats, the threshold voltage of the first transistor TR1 is changed, which may affect the operation of the display device 100. Therefore, the light-blocking layer LS may be electrically connected to the first source electrode SE1, such that the voltage may be applied to the light-blocking layer LS, and the operation of the first transistor TR1 is not affected. In the present specification, the configuration has been described in which both the first active layer ACT1 and the first source electrode SE1 are in contact with the light-blocking layer LS. However, only any one of the first source electrode SE1 and the first active layer ACT1 may be in direct contact with the light-blocking layer LS. The present disclosure is not limited thereto.

Meanwhile, FIG. 5 illustrates that the gate insulating layer 112 is patterned to overlap only the first gate electrode GE1, the first source electrode SE1, and the first drain electrode DE1. However, the gate insulating layer 112 may be formed on the entire surface of the substrate 110. The present disclosure is not limited thereto.

The second transistor TR2 includes the second active layer ACT2, a second gate electrode GE2, a second source electrode SE2, and a second drain electrode DE2.

The second active layer ACT2 is disposed on the buffer layer 111. The second active layer ACT2 may be made of a semiconductor material such as an oxide semiconductor, amorphous silicon, or polysilicon, but the present disclosure is not limited thereto. For example, in the case in which the second active layer ACT2 is made of an oxide semiconductor, the second active layer ACT2 may include a channel area, a source area, and a drain area. The source area and the drain area may be areas having conductivity. However, the present disclosure is not limited thereto.

The second source electrode SE2 is disposed on the buffer layer 111. The second source electrode SE2 may be integrated with and electrically connected to the second active layer ACT2. For example, the second source electrode SE2 may be formed by forming a semiconductor material on the buffer layer 111 and making a part of the semiconductor material conductive. Therefore, a portion of the semiconductor material, which does not become conductive, may be the second active layer ACT2. A portion of the semiconductor material, which becomes conductive, may be the second source electrode SE2. However, the second active layer ACT2 and the second source electrode SE2 may be separately formed. However, the present disclosure is not limited thereto.

The second source electrode SE2 is electrically connected to the first gate electrode GE1 of the first transistor TR1. The first gate electrode GE1 may be electrically connected to the second source electrode SE2 through the contact hole formed in the gate insulating layer 112. Therefore, the first transistor TR1 may be turned on or off in response to a signal from the second transistor TR2.

The gate insulating layer 112 is disposed on the second active layer ACT2 and the second source electrode SE2. The second drain electrode DE2 and the second gate electrode GE2 are disposed on the gate insulating layer 112.

The second gate electrode GE2 is disposed on the gate insulating layer 112 so as to overlap the second active layer ACT2. The second gate electrode GE2 may be electrically connected to the gate line GL. The second transistor TR2 may be turned on or off on the basis of the gate voltage transmitted to the second gate electrode GE2. The second gate electrode GE2 may be made of an electrically conductive material, for example, copper (Cu), aluminum (Al), molybdenum (Mo), nickel (Ni), titanium (Ti), chromium (Cr), or an alloy thereof. However, the present disclosure is not limited thereto.

Meanwhile, the second gate electrode GE2 may extend from the gate line GL. That is, the second gate electrode GE2 may be integrated with the gate line GL. The second gate electrode GE2 and the gate line GL may be made of the same electrically conductive material. For example, the gate line GL may be made of copper (Cu), aluminum (Al), molybdenum (Mo), nickel (Ni), titanium (Ti), chromium (Cr), or an alloy thereof. However, the present disclosure is not limited thereto.

The gate line GL is a line for transmitting the gate voltages to the plurality of subpixels SP. The gate line GL may extend in the row direction while traversing a circuit area of the plurality of subpixels SP. The gate line GL may extend in the row direction and intersect the plurality of high-potential power lines VDD, the plurality of data lines DL, and the plurality of reference lines RL that extend in the column direction.

The second drain electrode DE2 is disposed on the gate insulating layer 112. The second drain electrode DE2 may be electrically connected to the second active layer ACT2 through the contact hole formed in the gate insulating layer 112. The second drain electrode DE2 may be electrically connected to one of the plurality of data lines DL through the contact hole formed in the gate insulating layer 112 and the buffer layer 111. For example, the second drain electrode DE2 of the red subpixel SPR may be electrically connected to the first data line DL1. The second drain electrode DE2 of the white subpixel SPW may be electrically connected to the second data line DL2. For example, the second drain electrode DE2 of the blue subpixel SPB may be electrically connected to the third data line DL3. The second drain electrode DE2 of the green subpixel SPG may be electrically connected to the fourth data line DL4. The second drain electrode DE2 may be made of an electrically conductive material, for example, copper (Cu), aluminum (Al), molybdenum (Mo), nickel (Ni), titanium (Ti), chromium (Cr), or an alloy thereof. However, the present disclosure is not limited thereto.

The third transistor TR3 includes the third active layer ACT3, a third gate electrode GE3, a third source electrode SE3, and a third drain electrode DE3.

The third active layer ACT3 is disposed on the buffer layer 111. The third active layer ACT3 may be made of a semiconductor material such as an oxide semiconductor, amorphous silicon, or polysilicon, but the present disclosure is not limited thereto. For example, in the case in which the third active layer ACT3 is made of an oxide semiconductor, the third active layer ACT3 may include a channel area, a source area, and a drain area. The source area and the drain area may be areas having conductivity. However, the present disclosure is not limited thereto.

The gate insulating layer 112 is disposed on the third active layer ACT3. The third gate electrode GE3, the third source electrode SE3, and the third drain electrode DE3 are disposed on the gate insulating layer 112.

The third gate electrode GE3 is disposed on the gate insulating layer 112 so as to overlap the third active layer ACT3. The third gate electrode GE3 may be electrically connected to the sensing line SL. The third transistor TR3 may be turned on or off on the basis of the sensing voltage transmitted to the third transistor TR3. The third gate electrode GE3 may be made of an electrically conductive material, for example, copper (Cu), aluminum (Al), molybdenum (Mo), nickel (Ni), titanium (Ti), chromium (Cr), or an alloy thereof. However, the present disclosure is not limited thereto.

Meanwhile, the third gate electrode GE3 may extend from the sensing line SL. That is, the third gate electrode GE3 may be integrated with the sensing line SL. The third gate electrode GE3 and the sensing line SL may be made of the same electrically conductive material. For example, the sensing line SL may be made of copper (Cu), aluminum (Al), molybdenum (Mo), nickel (Ni), titanium (Ti), chromium (Cr), or an alloy thereof. However, the present disclosure is not limited thereto.

The sensing line SL is a line that transmits the sensing voltages to the plurality of subpixels SP and extends in the row direction between the plurality of subpixels SP. For example, the sensing line SL may extend in the row direction at a boundary between the plurality of subpixels SP and intersect the plurality of high-potential power lines VDD, the plurality of data lines DL, and the plurality of reference lines RL that extend in the column direction.

The third source electrode SE3 may be electrically connected to the third active layer ACT3 through the contact hole formed in the gate insulating layer 112. The third source electrode SE3 may be made of an electrically conductive material, for example, copper (Cu), aluminum (Al), molybdenum (Mo), nickel (Ni), titanium (Ti), chromium (Cr), or an alloy thereof. However, the present disclosure is not limited thereto.

Meanwhile, a part of the third active layer ACT3, which is in contact with the third source electrode SE3, may be electrically connected to the light-blocking layer LS through the contact hole formed in the buffer layer 111. That is, the third source electrode SE3 may be electrically connected to the light-blocking layer LS with the third active layer ACT3 interposed therebetween. Therefore, the third source electrode SE3 and the first source electrode SE1 may be electrically connected to each other through the light-blocking layer LS.

The third drain electrode DE3 may be electrically connected to the third active layer ACT3 through the contact hole formed in the gate insulating layer 112. The third drain electrode DE3 may be made of an electrically conductive material, for example, copper (Cu), aluminum (Al), molybdenum (Mo), nickel (Ni), titanium (Ti), chromium (Cr), or an alloy thereof. However, the present disclosure is not limited thereto.

The third drain electrode DE3 may be electrically connected to the reference line RL. For example, the third drain electrodes DE3 of the red subpixel SPR, the white subpixel SPW, the blue subpixel SPB, and the green subpixel SPG, which constitute the single pixel, may be electrically connected to the same reference line RL. That is, the plurality of subpixels SP, which constitutes a single pixel, may share the single reference line RL.

In this case, an auxiliary reference line RLa may be disposed to transmit signals to the plurality of subpixels SP disposed side by side in the row direction through the reference line RL extending in the column direction. The auxiliary reference line RLa may extend in the row direction and electrically connect the reference line RL to the third drain electrode DE3 of each of the plurality of subpixels SP. One end of the auxiliary reference line RLa may be electrically connected to the reference line RL through the contact hole formed in the buffer layer 111 and the gate insulating layer 112. Further, the other end of the auxiliary reference line RLa may be electrically connected to the third drain electrode DE3 of each of the plurality of subpixels SP. In this case, the auxiliary reference line RLa may be integrated with the third drain electrode DE3 of each of the plurality of subpixels SP. The reference voltage may be transmitted from the reference line RL to the third drain electrode DE3 through the auxiliary reference line RLa. However, the auxiliary reference line RLa may be formed separately from the third drain electrode DE3. However, the present disclosure is not limited thereto.

The storage capacitor SC is disposed in the circuit area of the plurality of subpixels SP. The storage capacitor SC may store a voltage between the first gate electrode GE1 and the first source electrode SE1 of the first transistor TR1 so that the light-emitting element OLED may continuously maintain the same state during a single frame. The storage capacitor SC includes a first capacitor electrode SC1, a second capacitor electrode SC2, and a third capacitor electrode SC3.

The first capacitor electrode SC1 is disposed between the insulating layer IN and the buffer layer 111 in each of the plurality of subpixels SP. The first capacitor electrode SC1 may be disposed to be closest to the substrate 110 among the conductive constituent elements disposed on the substrate 110. The first capacitor electrode SC1 may be made of the same material as the light-blocking layer LS or integrated with the light-blocking layer LS. The first capacitor electrode SC1 may be electrically connected to the first source electrode SE1 through the light-blocking layer LS.

The buffer layer 111 is disposed on the first capacitor electrode SC1. The second capacitor electrode SC2 is disposed on the buffer layer 111. The second capacitor electrode SC2 may be disposed to overlap the first capacitor electrode SC1. The second capacitor electrode SC2 may be integrated with the second source electrode SE2 and electrically connected to the second source electrode SE2 or the first gate electrode GE1. For example, the second source electrode SE2 and the second capacitor electrode SC2 may be formed by forming a semiconductor material on the buffer layer 111 and making a part of the semiconductor material conductive. Therefore, a portion of the semiconductor material, which does not become conductive, may serve as the second active layer ACT2. A portion of the semiconductor material, which becomes conductive, may serve as the second source electrode SE2 or the second capacitor electrode SC2. Further, as described above, the first gate electrode GE1 is electrically connected to the second source electrode SE2 through the contact hole formed in the gate insulating layer 112. Therefore, the second capacitor electrode SC2 may be integrated with the second source electrode SE2 and electrically connected to the second source electrode SE2 and the first gate electrode GE1.

The passivation layer 113 is disposed on the second capacitor electrode SC2. The third capacitor electrode SC3 is disposed on the passivation layer 113. The third capacitor electrode SC3 may be disposed to overlap the first capacitor electrode SC1 and the second capacitor electrode SC3. The third capacitor electrode SC3 may be integrated with the anode AN and electrically connected to the first source electrode SE1.

In summary, the first capacitor electrode SC1 of the storage capacitor SC may be integrated with the light-blocking layer LS and electrically connected to the light-blocking layer LS, the first source electrode SE1, and the third source electrode SE3. Further, the second capacitor electrode SC2 may be integrated with the second source electrode SE2 or the second active layer ACT2 and electrically connected to the second source electrode SE2 and the first gate electrode GE1. In addition, the third capacitor electrode SC3 may be integrated with the anode AN and electrically connected to the first source electrode SE1 and the third source electrode SE3. Therefore, the first and second capacitor electrodes SC1 and SC2, which overlap each other with the buffer layer 111 interposed therebetween, and the second and third capacitor electrodes SC2 and SC3, which overlap each other with the passivation layer 113 interposed therebetween, may maintain the light-emitting element OLED in the constant state by constantly maintaining the voltages of the first gate electrode GE1 and the first source electrode SE1 of the first transistor TR1 while the light-emitting element OLED emits light.

The passivation layer 113 is disposed on the first transistor TR1, the second transistor TR2, the third transistor TR3, and the storage capacitor SC. The passivation layer 113 is an insulating layer for protecting the components disposed below the passivation layer 113. For example, the passivation layer 113 may be configured as a single layer or multilayer made of silicon oxide (SiOx) or silicon nitride (SiNx). However, the present disclosure is not limited thereto. In addition, the passivation layer 113 may be eliminated in accordance with the embodiments.

The plurality of color filters CF is disposed in the light-emitting area of each of the plurality of subpixels SP and provided on the passivation layer 113. As described above, the display device 100 according to the embodiment of the present disclosure is the bottom-emission type display device that allows the light emitted from the light-emitting element OLED to propagate to the lower sides of the light-emitting element OLED and the substrate 110. Therefore, the plurality of color filters CF may be disposed below the light-emitting element OLED. The light emitted from the light-emitting element OLED may be implemented in the form of light beams with various colors by passing through the plurality of color filters CF.

The plurality of color filters CF includes the red color filter CFR, a blue color filter CFB, and the green color filter CFG. The red color filter CFR may be disposed in the light-emitting area of the red subpixel SPR among the plurality of subpixels SP. The blue color filter CFB may be disposed in the light-emitting area of the blue subpixel SPB. The green color filter CFG may be disposed in the light-emitting area of the green subpixel SPG.

The planarization layer 114 is disposed on the passivation layer 113 and the plurality of color filters CF. The planarization layer 114 is an insulating layer for flattening upper portions of the plurality of substrates 110 on which the first transistor TR1, the second transistor TR2, the third transistor TR3, the storage capacitor SC, the plurality of high-potential power lines VDD, the plurality of data lines DL, the plurality of reference lines RL, the plurality of gate lines GL, and the plurality of sensing lines SL are disposed. The planarization layer 114 may be configured as a single layer or multilayer made of an organic material, for example, polyimide or photo acrylic. However, the present disclosure is not limited thereto.

The light-emitting element OLED is disposed in the light-emitting area of each of the plurality of subpixels SP. The light-emitting element OLED is disposed on the planarization layer 114 of each of the plurality of subpixels SP. The light-emitting element OLED includes the anode AN, a light-emitting layer EL, and the cathode CA.

The anode AN is disposed on the planarization layer 114 in the light-emitting area EA. Because the anode AN supplies holes to the light-emitting layer EL, the anode AN may be made of an electrically conductive material having a high work function and may also be called an anode AN. For example, the anode AN may be made of a transparent electrically conductive material such as indium tin oxide (ITO) or indium zinc oxide (IZO), but the present disclosure is not limited thereto.

Meanwhile, the anode AN may extend toward the circuit area. A part of the anode AN may extend from the light-emitting area toward the first source electrode SE1 of the circuit area and be electrically connected to the first source electrode SE1 through the contact hole formed in the planarization layer 114 and the passivation layer 113. Therefore, the anode AN of the light-emitting element OLED may extend to the circuit area and be electrically connected to the first source electrode SE1 of the first transistor TR1 or the second capacitor electrode SC2 of the storage capacitor SC.

The light-emitting layer EL is disposed on the anode AN in the light-emitting area and the circuit area. The light-emitting layer EL may be configured as a single layer over the plurality of subpixels SP. That is, the light-emitting layers EL of the plurality of subpixels SP may be connected to and integrated with one another. The light-emitting layer EL may be configured as a single light-emitting layer. The light-emitting layer EL may have a structure in which a plurality of light-emitting layers configured to emit light beams with different colors is stacked. The light-emitting layer EL may further include organic layers such as a hole injection layer, a hole transport layer, an electron transport layer, and an electron injection layer.

The cathode CA is disposed on the light-emitting layer EL in the light-emitting area and circuit area. Because the cathode CA supplies electrons to the light-emitting layer EL, the cathode CA may be made of an electrically conductive material having a low work function. The cathode CA may be configured as a single layer over the plurality of subpixels SP. That is, the cathodes CA of the plurality of subpixels SP may be connected to and integrated with one another. For example, the cathode CA may be made of an electrically transparent conductive material such as indium tin oxide (ITO) or indium zinc oxide (IZO) or made of an alloy of ytterbium (Yb). The cathode CA may further include a metal doping layer, but the present specification is not limited thereto. Meanwhile, although not illustrated in FIGS. 4A to 5, the cathode CA of the light-emitting element OLED may be electrically connected to the low-potential power line VSS and receive the low-potential power voltage.

The bank 115 is disposed between the anode AN and the light-emitting layer EL. The bank 115 is disposed to overlap the display area AA and cover an edge of the anode AN. The bank 115 may be disposed at a boundary between the adjacent subpixels SP and reduce mixing of colors of the light beams emitted from the light-emitting element OLED of each of the plurality of subpixels SP. The bank 115 may be made of an insulating material. For example, the bank 115 may be made of polyimide-based resin, acryl-based resin, or benzocyclobutene (BCB)-based resin. However, the present disclosure is not limited thereto.

The substrate 110 of the display device 100 according to the embodiment of the present disclosure is made of any one of the transparent conducting oxide and the oxide semiconductor. Therefore, the display device 100 may decrease in thickness. In the related art, a plastic or glass substrate is mainly used as the substrate of the display device. For this reason, the plastic or glass substrate is hardly formed to have a thickness thin at a predetermined level or less. In contrast, the transparent conducting oxide and the oxide semiconductor may allow the display device to have a very small thickness through a deposition process such as sputtering. Therefore, in the display device 100 according to the embodiment of the present disclosure, the substrate 110 for supporting several components of the display device 100 is made of the transparent conducting oxide layer or oxide semiconductor layer. Therefore, it is possible to reduce a thickness of the display device 100 and implement slim design.

Meanwhile, the flexible display device is formed by forming the light-emitting element and the drive circuit on the plastic substrate more flexible than the glass substrate. However, if the display device is excessively deformed, the display device may be damaged by stress caused by the deformation. Therefore, even though it is more advantageous to reduce the thickness of the display device in order to further improve flexibility to mitigate stress on the display device, it is difficult to reduce a thickness of the plastic substrate to a predetermined level or less, as described above.

Therefore, in the display device 100 according to the embodiment of the present disclosure, the substrate 110 is made of the transparent conducting oxide or oxide semiconductor, such that it is possible to improve the flexibility of the display device 100 or reduce stress caused by the deformation of the display device 100. Specifically, when the substrate 110 is made of the transparent conducting oxide layer or oxide semiconductor, the substrate 110 may be formed to have a very thin film. In this case, the substrate 110 may be called a first transparent thin-film layer. Therefore, the display device 100 including the substrate 110 may have high flexibility. Therefore, the display device 100 may be easily curved or rolled up. Therefore, in the display device 100 according to the embodiment of the present disclosure, the substrate 110 is made of any one of the transparent conducting oxide layer and the oxide semiconductor layer, such that it is possible to improve flexibility of the display device 100 and reduce stress caused by the deformation of the display device 100. Therefore, it is possible to minimize cracks formed in the display device 100.

Meanwhile, the flexible display device is implemented by using the plastic substrate instead of the glass substrate, but the plastic substrate increases the likelihood of static electricity in comparison with the glass substrate. The static electricity may affect various types of lines and driving elements on the plastic substrate, which may damage some components or degrade display quality of the display device. Therefore, there is a need for a separate component for blocking and discharging static electricity on the display device using the plastic substrate.

In the display device 100 according to the embodiment of the present disclosure, the substrate 110 may be made of any one of the transparent conducting oxide layer and the oxide semiconductor layer, thereby reducing the likelihood that the static electricity occurs on the substrate 110. If the substrate 110 is made of plastic and the static electricity occurs, various types of lines and driving elements on the substrate 110 may be damaged by the static electricity, or the static electricity may affect the operations of the lines and components, which may deteriorate the display quality. Instead, the substrate 110 is made of the transparent conducting oxide layer or oxide semiconductor layer, it is possible to minimize the static electricity occurring on the substrate 110 and simplify the configuration for blocking and discharging the static electricity. Therefore, in the display device 100 according to the embodiment of the present disclosure, the substrate 110 is made of any one of the transparent conducting oxide layer or oxide semiconductor layer that is low in the likelihood of the occurrence of the static electricity. Therefore, it is possible to minimize damage or deterioration in display quality caused by the static electricity.

Meanwhile, when the plastic substrate is used as the substrate of the display device, particles may occur during a process of forming the plastic substrate. For example, particles may occur during a process of applying and curing a substrate material to form the plastic substrate. Further, moisture and oxygen may more easily penetrate into the display device because of the particles. Further, several components may be non-uniformly formed on the substrate because of the particles. Therefore, in the case of the plastic substrate formed by applying and curing the substrate material, the particles may degrade the light-emitting element in the display device or deteriorate the characteristics of the transistor.

In contrast, in the display device 100 according to the embodiment of the present disclosure, the substrate 110 is made of one of the transparent conducting oxide and the oxide semiconductor. Therefore, it is possible to minimize the penetration of outside moisture or oxygen into the display device 100 through the substrate 110. When the substrate 110 is made of the transparent conducting oxide layer or oxide semiconductor layer, the substrate 110 is formed in a vacuum environment, such that the likelihood of the occurrence of particles is remarkably low. In addition, sizes of the particles are very small even though the particles occur. Therefore, it is possible to minimize the penetration of moisture and oxygen into the display device 100. Therefore, in the display device 100 according to the embodiment of the present disclosure, the substrate 110 is made of the transparent conducting oxide or oxide semiconductor that decreases the likelihood of the occurrence of particles and is excellent in moisture transmission performance. Therefore, it is possible to improve reliability of the display device 100 and the light-emitting element OLED including the organic layer.

Further, in the display device 100 according to the embodiment of the present disclosure, the substrate 110 is made of any one of the transparent conducting oxide and the oxide semiconductor. Further, the substrate 110 may be used in a state in which a thin, inexpensive barrier film is attached to a lower portion of the substrate 110. In a case in which the substrate 110 is made of a material, for example, a plastic material having low moisture transmission performance, the moisture transmission performance may be improved by attaching the thick, expensive barrier film having high performance. However, in the display device 100 according to the embodiment of the present disclosure, the substrate 110 is made of the transparent conducting oxide or oxide semiconductor that is excellent in moisture transmission performance. Therefore, the thin, inexpensive barrier film may be attached to the lower portion of the substrate 110. Therefore, in the display device 100 according to the embodiment of the present disclosure, the substrate 110 is made of any one of the transparent conducting oxide and the oxide semiconductor that are in excellent in moisture transmission performance. Therefore, it is possible to reduce manufacturing costs for the display device.

In the display device 100 according to the embodiment of the present disclosure, the substrate 110 is made of any one of the transparent conducting oxide and the oxide semiconductor. Therefore, it is possible to perform a laser-lift-off (LLO) process. During the process of manufacturing the display device 100, the pixel part 120 may be formed on the substrate 110 by attaching a temporary substrate having a sacrificial layer to a lower portion of the substrate 110. The sacrificial layer may be made of, for example, hydrogenated amorphous silicon or amorphous silicon hydrogenated and doped with impurities. Further, when laser beams are emitted to the lower portion of the temporary substrate after the display device 100 is completely manufactured, the sacrificial layer may be dehydrogenated, and the sacrificial layer and the temporary substrate may be separated from the substrate 110. In this case, the transparent conducting oxide and the oxide semiconductor are the materials that may be subjected to the LLO process together with the sacrificial layer and the temporary substrate. Therefore, even though the substrate 110 is made of any one of the transparent conducting oxide and the oxide semiconductor, the substrate 110 and the temporary substrate may be easily separated. Therefore, in the display device 100 according to the embodiment of the present disclosure, the substrate 110 made of any one of the transparent conducting oxide layer and the oxide semiconductor that may be subjected to the LLO process. Therefore, it is possible to easily manufacture the display device 100 even by using a process and an apparatus in the related art.

In addition, in the display device 100 according to the embodiment of the present disclosure, the signal line for transmitting the alternating current voltage is disposed so as not to overlap the substrate 110. Therefore, it is possible to reduce parasitic capacitance occurring in the signal line for transmitting the alternating current voltage.

Specifically, when the substrate 110 is made of a transparent conducting oxide or oxide semiconductor, the parasitic capacitance may occur between the substrate 110 and the signal lines. In particular, a large amount of parasitic capacitance occurs in the signal line for transmitting the alternating current voltage, for example, the data line DL or the reference line RL, which may cause noise in the signal line. When the parasitic capacitance occurs in the signal line such as the data line DL or the reference line RL as described above, an RC delay may occur.

Therefore, in the display device 100 according to the embodiment of the present disclosure, the plurality of substrates 110 is disposed to be spaced apart from one another, and the signal line for transmitting the alternating current voltage is disposed in the region in which the plurality of substrates 110 is spaced apart from one another. Therefore, the substrate 110 made of the transparent conducting oxide or oxide semiconductor is disposed so as not to overlap the signal line for receiving the alternating current voltage. Therefore, it is possible to minimize the parasitic capacitance occurring in the signal line for transmitting the alternating current voltage. Therefore, in the display device 100 according to the embodiment of the present disclosure, the signal line for transmitting the alternating current voltage is disposed so as not to overlap the plurality of substrates 110. Therefore, it is possible to reduce the parasitic capacitance occurring in the signal line for transmitting the alternating current voltage and minimize the RC delay caused by noise occurring in the signal line.

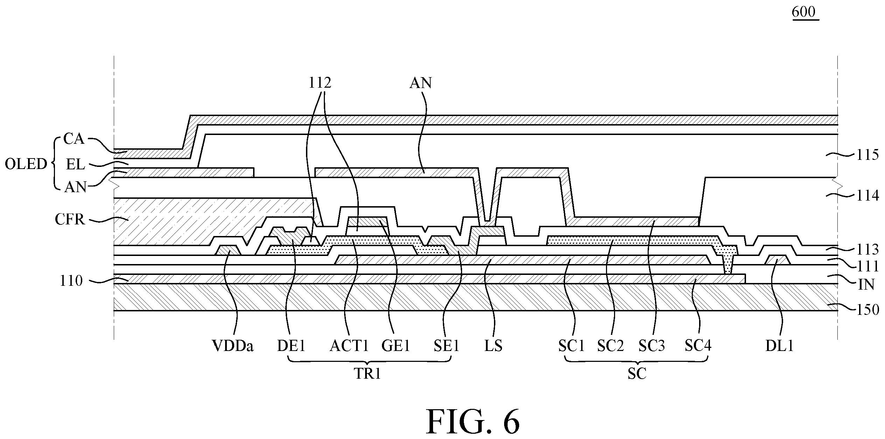

FIG. 6 is a cross-sectional view of a display device according to another embodiment of the present disclosure. A display device 600 illustrated in FIG. 6 is substantially identical in configuration to the display device 100 illustrated in FIGS. 1 to 5, except that the storage capacitor SC further includes a fourth capacitor electrode SC4. Therefore, repeated descriptions of the identical components will be omitted.

Referring to FIG. 6, the storage capacitor SC includes the first capacitor electrode SC1, the second capacitor electrode SC2, the third capacitor electrode SC3, and the fourth capacitor electrode SC4. The first to third capacitor electrodes SC1, SC2, and SC3 are substantially identical to the first to third capacitor electrodes SC1, SC2, and SC3 illustrated in FIGS. 1 to 5.

The fourth capacitor electrode SC4 may be a substrate 110 electrically connected to the second capacitor electrode SC2. That is, the substrate 110 may serve as the fourth capacitor electrode SC4 of the storage capacitor SC. In this case, the fourth capacitor electrode SC4 may be electrically connected to the second capacitor electrode SC2 through the contact hole formed in the insulating layer IN and the buffer layer 111.

The display device 600 according to another embodiment of the present disclosure includes the first capacitor electrode SC1, the second capacitor electrode SC2, the third capacitor electrode SC3, and the fourth capacitor electrode SC4. Therefore, it is possible to maintain the light-emitting element OLED in the constant state by constantly maintaining the voltages of the first gate electrode GE1 and the first source electrode SE1 of the first transistor TR1 while the light-emitting element OLED emits light.

Specifically, the first capacitor electrode SC1 of the storage capacitor SC may be integrated with the light-blocking layer LS and electrically connected to the light-blocking layer LS, the first source electrode SE1, and the third source electrode SE3. The second capacitor electrode SC2 may be integrated with the second source electrode SE2 or the second active layer ACT2 and electrically connected to the second source electrode SE2 and the first gate electrode GE1. Further, the third capacitor electrode SC3 may extend from the anode AN of the light-emitting element OLED and be electrically connected to the second capacitor electrode SC2. The fourth capacitor electrode SC4 may be the substrate 110 electrically connected to the second capacitor electrode SC2 through the contact hole formed in the insulating layer IN and the buffer layer 111. In this case, the fourth capacitor electrode SC4 may overlap the first capacitor electrode SC1 with the insulating layer IN interposed therebetween and define a capacitor together with the first capacitor electrode SC1. Therefore, since the display device 600 according to the embodiment of the present disclosure includes the first capacitor electrode SC1, the second capacitor electrode SC2, the third capacitor electrode SC3, and the fourth capacitor electrode SC4, it is possible to additionally provide the capacitor constituting the storage capacitor SC, for example, the capacitor including the first capacitor electrode SC1 and the fourth capacitor electrode SC4. Therefore, the display device 600 according to the embodiment of the present disclosure may reduce the parasitic capacitance occurring in the signal line for transmitting the alternating current voltage, increase a capacity of the storage capacitor SC, and more stably operate the light-emitting element OLED.

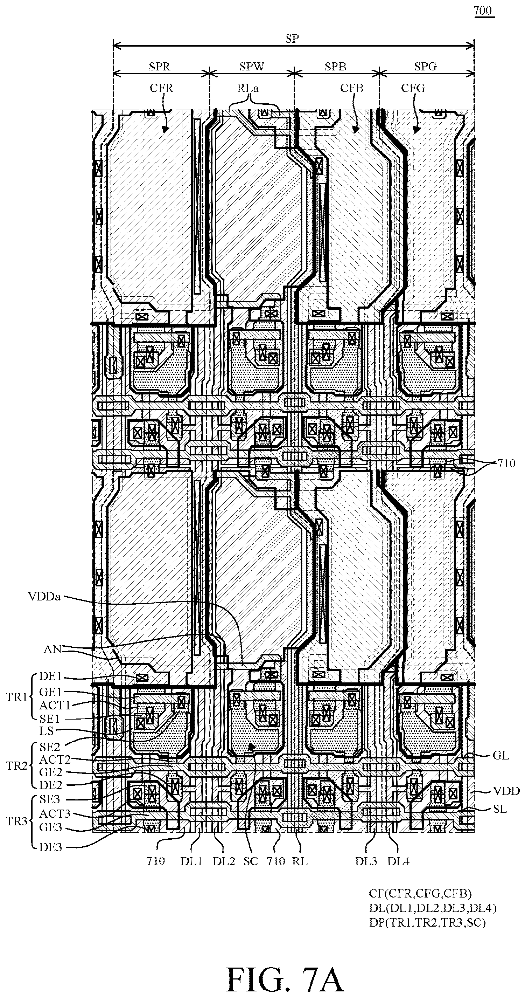

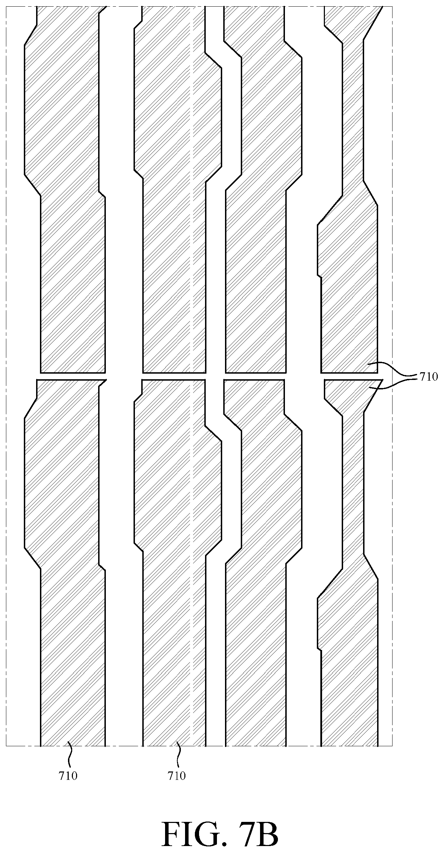

FIG. 7A is an enlarged top plan view of a display device according to still another embodiment of the present disclosure. FIG. 7B is an enlarged top plan view of a plurality of substrates in FIG. 7A. For the convenience of description, FIG. 7B illustrates only a plurality of substrates 710 among various constituent elements of a display device 700. The display device 700 illustrated in FIGS. 7A and 7B is substantially identical in configuration to the display device 600 illustrated in FIG. 6, except for the arrangement of the plurality of substrates 710. Therefore, repeated descriptions of the identical components will be omitted.

Referring to FIGS. 7A and 7B, the plurality of substrates 710 may be arranged in a matrix shape to correspond to the plurality of subpixels SP, respectively. That is, the plurality of substrates 710 may each be patterned and disposed to correspond to the single subpixel SP. Therefore, in the display area AA, the number of substrates 710 may be equal to the number of subpixels SP.

In the display device 700 according to the embodiment of the present disclosure, the plurality of substrates 710 may be arranged in a matrix shape to correspond to the plurality of subpixels SP, respectively. Therefore, the plurality of subpixels SP for receiving different signals may be more stably operated.

Specifically, the plurality of substrates 710 is disposed to be spaced apart from one another, and the signal lines such as the data line DL or the reference line RL for transmitting the alternating current voltage are disposed in the region in which the plurality of substrates 710 is spaced apart from one another. Therefore, the substrate 710 made of the transparent conducting oxide or oxide semiconductor is disposed so as not to overlap the signal line for receiving the alternating current voltage. Therefore, it is possible to minimize the parasitic capacitance occurring in the signal line for transmitting the alternating current voltage.

In addition, in the display device 700 according to the embodiment of the present disclosure, the plurality of substrates 710 may be arranged in a matrix shape to correspond to the plurality of subpixels SP, respectively. That is, the plurality of substrates 710 may be patterned and disposed to correspond to the plurality of subpixels SP, respectively. Therefore, the plurality of substrates 710 respectively disposed in the plurality of subpixels SP may be electrically separated from one another. The plurality of fourth capacitor electrodes SC4 disposed in the plurality of subpixels SP may also be electrically separated from one another. Therefore, in the display device 700 according to the embodiment of the present disclosure, the plurality of substrates 710 may be arranged in a matrix shape to correspond to the plurality of subpixels SP, respectively. Therefore, the plurality of subpixels SP for receiving different signals may be more stably operated.

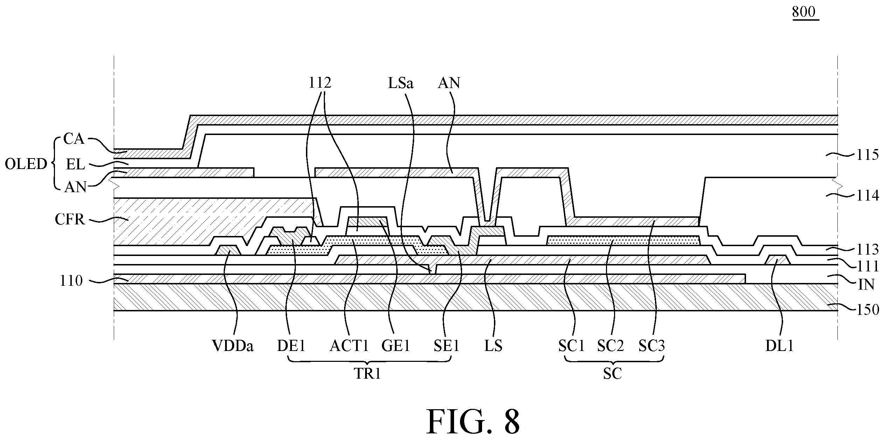

FIG. 8 is a cross-sectional view of a display device according to yet another embodiment of the present disclosure. The display device 800 illustrated in FIG. 8 is substantially identical in configuration to the display device 100 illustrated in FIGS. 1 to 5, except that a light-blocking layer connection portion LSa is further provided. Therefore, repeated descriptions of the identical components will be omitted.

Referring to FIG. 8, the first source electrode SE1 may be electrically connected to the light-blocking layer LS through the contact hole formed in the gate insulating layer 112 and the buffer layer 111. In addition, a part of the first active layer ACT1 connected to the first source electrode SE1 may be electrically connected to the light-blocking layer LS through the contact hole formed in the buffer layer 111. However, in the present specification, the configuration has been described in which the light-blocking layer LS is connected to the first source electrode SE1. However, the light-blocking layer LS may be connected to the first drain electrode DE1. The present disclosure is not limited thereto.

Further, the light-blocking layer connection portion LSa may be disposed on the light-blocking layer LS. The light-blocking layer connection portion LSa extends from the light-blocking layer LS and is connected to the substrate 110 through the contact hole formed in the insulating layer IN. Therefore, the light-blocking layer LS may be electrically connected to the substrate 110 through the light-blocking layer connection portion LSa.

In the display device 800 according to the embodiment of the present disclosure, the light-blocking layer connection portion LSa is further disposed on the light-blocking layer LS. Therefore, the substrate 110 and the light-blocking layer LS may be electrically connected. Therefore, the first source electrode SE1 may be electrically connected to the substrate 110, thereby more stably operating the first transistor TR1.

Specifically, when the substrate made of the transparent conducting oxide or oxide semiconductor floats, the threshold voltage of the first transistor is changed, which may affect the operation of the display device. Therefore, the light-blocking layer LS connected to the first source electrode SE1 may be electrically connected to the substrate 110, thereby applying the voltage, which is equal to the voltage of the first source electrode SE1, to the substrate 110. Therefore, it is possible to minimize the influence on the operation of the first transistor TR1 by the substrate 110 disposed on the lower portion of the light-blocking layer LS. Therefore, in the display device 800 according to the embodiment of the present disclosure, the light-blocking layer connection portion LSa is further disposed on the light-blocking layer LS. Therefore, the substrate 110 and the light-blocking layer LS may be electrically connected. Therefore, the first source electrode SE1 may be electrically connected to the substrate 110, thereby more stably operating the first transistor TR1.

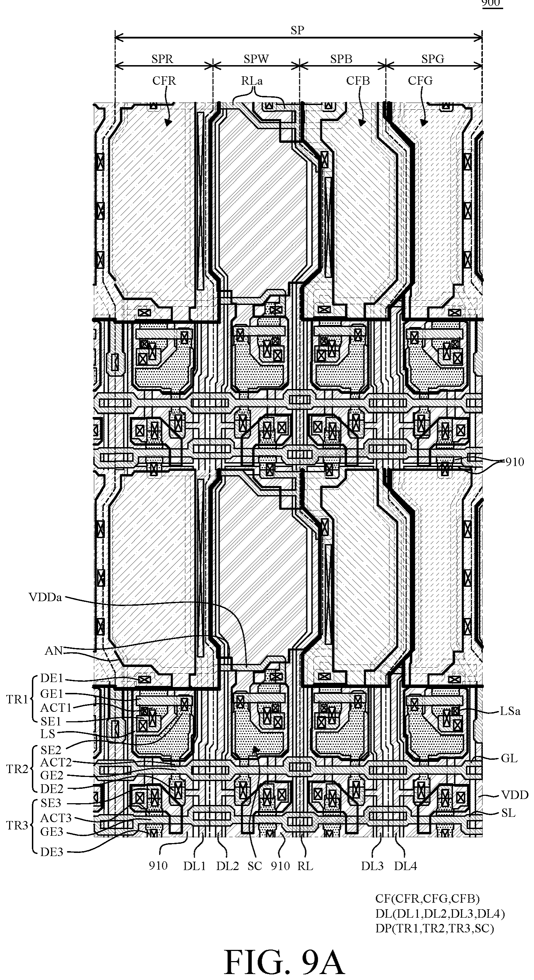

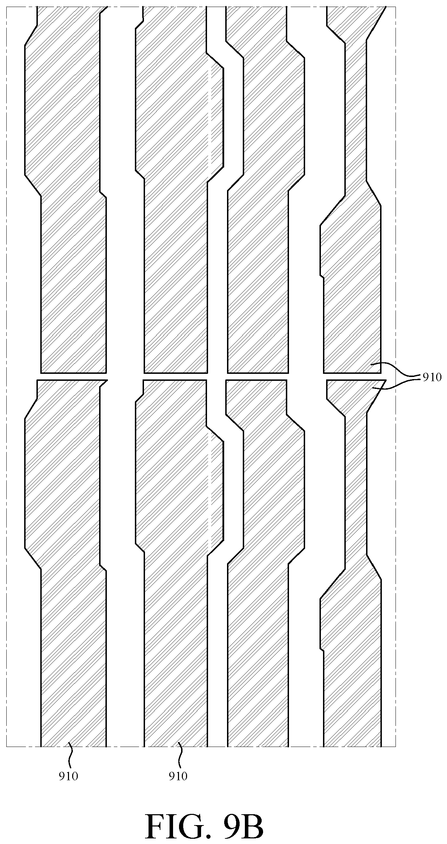

FIG. 9A is an enlarged top plan view of a display device according to still yet another embodiment of the present disclosure. FIG. 9B is an enlarged top plan view of a plurality of substrates in FIG. 9A. For the convenience of description, FIG. 9B illustrates only a plurality of substrates 910 among various constituent elements of a display device 900. The display device 900 illustrated in FIGS. 9A and 9B is substantially identical in configuration to the display device 800 illustrated in FIG. 8, except for the arrangement of the plurality of substrates 910. Therefore, repeated descriptions of the identical components will be omitted.

Referring to FIGS. 9A and 9B, the plurality of substrates 910 may be arranged in a matrix shape to correspond to the plurality of subpixels SP, respectively. That is, the plurality of substrates 910 may each be patterned and disposed to correspond to the single subpixel SP. Therefore, in the display area AA, the number of substrates 910 may be equal to the number of subpixels SP.

In the display device 900 according to the embodiment of the present disclosure, the plurality of substrates 910 may be arranged in a matrix shape to correspond to the plurality of subpixels SP, respectively. Therefore, the plurality of subpixels SP for receiving different signals may be more stably operated.

Specifically, the plurality of substrates 910 is disposed to be spaced apart from one another, and the signal lines such as the data line DL or the reference line RL for transmitting the alternating current voltage are disposed in the region in which the plurality of substrates 910 is spaced apart from one another. Therefore, the substrate 910 made of the transparent conducting oxide or oxide semiconductor is disposed so as not to overlap the signal line for receiving the alternating current voltage. Therefore, it is possible to minimize the parasitic capacitance occurring in the signal line for transmitting the alternating current voltage.

In addition, in the display device 900 according to the embodiment of the present disclosure, the plurality of substrates 910 may be arranged in a matrix shape to correspond to the plurality of subpixels SP, respectively. That is, the plurality of substrates 910 may be patterned and disposed to correspond to the plurality of subpixels SP, respectively. Therefore, the plurality of substrates 910 respectively disposed in the plurality of subpixels SP may be electrically separated from one another. Therefore, in the display device 900 according to the embodiment of the present disclosure, the plurality of substrates 910 may be arranged in a matrix shape to correspond to the plurality of subpixels SP, respectively. Therefore, the plurality of subpixels SP for receiving different signals may be more stably operated.

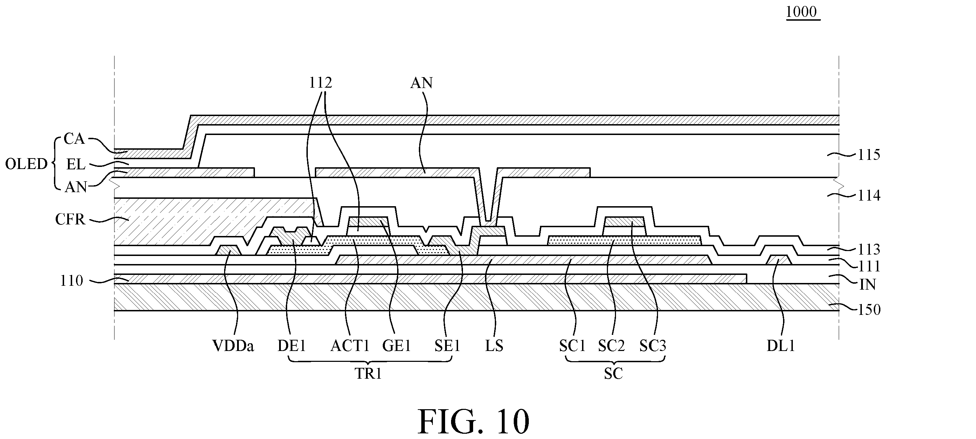

FIG. 10 is a cross-sectional view of a display device according to a further embodiment of the present disclosure. A display device 1000 illustrated in FIG. 10 is substantially identical in configuration to the display device 100 illustrated in FIGS. 1 to 5, except for the third capacitor electrode SC3. Therefore, repeated descriptions of the identical components will be omitted.

Referring to FIG. 10, the storage capacitor SC includes the first capacitor electrode SC1, the second capacitor electrode SC2, and the third capacitor electrode SC3. The first and second capacitor electrodes SC1 and SC2 are substantially identical to the first and second capacitor electrodes SC1 and SC2 illustrated in FIGS. 1 to 5.

Referring to FIG. 10, the gate insulating layer 112 may be disposed on the second capacitor electrode SC2. The third capacitor electrode SC3, which is made of the same material as the first gate electrode GE1, may be disposed on the gate insulating layer 112. The third capacitor electrode SC3 may be disposed to overlap the first capacitor electrode SC1 and the second capacitor electrode SC2. Therefore, the third capacitor electrode SC3 may define the capacitor together with the first and second capacitor electrodes SC1 and SC2. In this case, the anode AN of the light-emitting element OLED may be disposed so as not to overlap the third capacitor electrode SC3. Therefore, the anode AN and the third capacitor electrode SC3 do not electrically interfere with each other.

The display device 1000 according to the embodiment of the present disclosure includes the first capacitor electrode SC1, the second capacitor electrode SC2, and the third capacitor electrode SC3. Therefore, it is possible to maintain the light-emitting element OLED in the constant state by constantly maintaining the voltages of the first gate electrode GE1 and the first source electrode SE1 of the first transistor TR1 while the light-emitting element OLED emits light.

Specifically, the first capacitor electrode SC1 of the storage capacitor SC may be integrated with the light-blocking layer LS and electrically connected to the light-blocking layer LS, the first source electrode SE1, and the third source electrode SE3. Further, the second capacitor electrode SC2 may be integrated with the second source electrode SE2 or the second active layer ACT2 and electrically connected to the second source electrode SE2 and the first gate electrode GE1. In addition, the third capacitor electrode SC3 may be made of the same material as the first gate electrode GE1 and disposed to overlap the second capacitor electrode SC2 with the gate insulating layer 112 interposed therebetween, thereby defining the capacitor together with the second capacitor electrode SC2. Therefore, the first and second capacitor electrodes SC1 and SC2, which overlap each other with the buffer layer 111 interposed therebetween, and the second and third capacitor electrodes SC2 and SC3, which overlap each other with the gate insulating layer 112 interposed therebetween, may maintain the light-emitting element OLED in the constant state by constantly maintaining the voltages of the first gate electrode GE1 and the first source electrode SE1 of the first transistor TR1 while the light-emitting element OLED emits light. Therefore, the display device 1000 according to the embodiment of the present disclosure includes the first capacitor electrode SC1, the second capacitor electrode SC2, and the third capacitor electrode SC3. Therefore, it is possible to maintain the light-emitting element OLED in the constant state by constantly maintaining the voltages of the first gate electrode GE1 and the first source electrode SE1 of the first transistor TR1 while the light-emitting element OLED emits light. Therefore, it is possible to more stably operate the light-emitting element OLED.

The exemplary embodiments of the present disclosure can also be described as follows:

According to an aspect of the present disclosure, a display device may include a plurality of substrates disposed in a plurality of subpixels and configured one of a transparent conducting oxide layer or an oxide semiconductor layer; a plurality of transistors respectively disposed on the plurality of substrates and provided in the plurality of subpixels, respectively; a plurality of data lines extending in a column direction between the plurality of subpixels and configured to transmit data voltages to the plurality of subpixels; and a plurality of light-emitting elements respectively disposed in the plurality of subpixels and electrically connected to the plurality of transistors, in which the plurality of substrates is disposed to spaced apart from one another, and in which the plurality of data lines is disposed in a region in which the plurality of substrates is spaced apart from one another.

The plurality of substrates may extend in a column direction.

The display device may further comprise a light-blocking layer disposed on the plurality of substrates so as to overlap the plurality of transistors; and a storage capacitor comprising a fourth capacitor electrode which is the plurality of substrates, a first capacitor electrode made of the same material as the light-blocking layer, and a second capacitor electrode made of the same material as an active layer of the plurality of transistors, wherein the fourth capacitor electrode and the second capacitor electrode are connected to each other.

The storage capacitor may further comprise a third capacitor electrode made of the same material as an anode of the plurality of light-emitting elements or made of the same material as a gate electrode of the plurality of transistors.

The plurality of substrates may be spaced apart from one another so as to correspond to the plurality of subpixels, respectively.

The display device may further comprise a light-blocking layer disposed on the plurality of substrates so as to overlap the plurality of transistors.

The light-blocking layer may be connected to a source electrode or a drain electrode of the plurality of transistors, and the plurality of substrates may be connected to the light-blocking layer.

The plurality of transistors may be a driving transistor.

The plurality of substrates may be arranged in a matrix shape so as to correspond to the plurality of subpixels, respectively.

The display device may further comprise a plurality of reference lines extending in a column direction between the plurality of subpixels and configured to transmit reference voltages to the plurality of subpixels.

The plurality of reference lines may be disposed in the region in which the plurality of substrates is spaced apart from one another.

A rim, which faces the plurality of data lines and the plurality of reference lines among rims of the plurality of substrates, may parallel to the plurality of data lines and the plurality of reference lines.

According to another aspect of the present disclosure, a display device may include a plurality of substrates configured one of a transparent conducting oxide layer or an oxide semiconductor layer and having a pixel area in which a plurality of subpixels is disposed; a plurality of transistors electrically connected to the plurality of subpixels, respectively; a plurality of signal lines extending in a column direction between the plurality of subpixels and configured to transmit alternating current voltages; and a plurality of light-emitting elements respectively disposed in the plurality of subpixels and electrically connected to the plurality of transistors, in which the plurality of substrates is disposed to spaced apart from one another, and in which the plurality of signal lines is disposed in a region in which the plurality of substrates is spaced apart from one another.

The display device may further comprise a light-blocking layer disposed to overlap the plurality of transistors; and a storage capacitor comprising a plurality of capacitor electrodes.

The plurality of capacitor electrodes may comprise a fourth capacitor electrode which is the plurality of substrates; a first capacitor electrode made of the same material as the light-blocking layer; and a second capacitor electrode made of the same material as an active layer of the plurality of transistors.

The storage capacitor may further comprise a third capacitor electrode made of the same material as an anode of the plurality of light-emitting elements or made of the same material as a gate electrode of the plurality of transistors.

The plurality of substrates may be spaced apart from one another so as to correspond to the plurality of subpixels, respectively.

The display device may further comprise a light-blocking layer disposed on the plurality of substrates so as to overlap the plurality of transistors.

The light-blocking layer may be connected to a source electrode or a drain electrode of the plurality of transistors, and the plurality of substrates may be connected to the light-blocking layer.

The display device described herein may comprise: a plurality of substrates, each of the plurality of substrates being disposed in a respective subpixel of the plurality of subpixels, each of the plurality of substrates comprising: one of a transparent conducting oxide layer or an oxide semiconductor layer; multiple transistors disposed on the respective substrate and provided in the respective subpixel; and a light-emitting element disposed in the respective subpixel and connected to at least one transistor of the multiple transistors; a plurality of data lines each extending in a column direction between respective subpixels of the plurality of subpixels and each being configured to transmit a respective data voltage to at least one of the respective subpixels of the plurality of subpixels, wherein the substrates of the plurality of substrates are disposed spaced apart from one another, and wherein the plurality of data lines is disposed in a region in which the substrates are spaced apart from one another.

Although the exemplary embodiments of the present disclosure have been described in detail with reference to the accompanying drawings, the present disclosure is not limited thereto and may be embodied in many different forms without departing from the technical concept of the present disclosure. Therefore, the exemplary embodiments of the present disclosure are provided for illustrative purposes only but not intended to limit the technical concept of the present disclosure. The scope of the technical concept of the present disclosure is not limited thereto. Therefore, it should be understood that the above-described exemplary embodiments are illustrative in all aspects and do not limit the present disclosure. The protective scope of the present disclosure should be construed based on the following claims, and all the technical concepts in the equivalent scope thereof should be construed as falling within the scope of the present disclosure.

## Claims

1. A display device (100, 600, 700, 800, 900, 1000) comprising:
a plurality of substrates (110, 710, 910), each of the plurality of substrates being disposed in a respective subpixel (SP, SPR, SPW, SPB, SPG) of a plurality of subpixels and comprising one of a transparent conducting oxide layer or an oxide semiconductor layer;
a plurality of transistors (TR1, TR2, TR3) disposed on respective substrates of the plurality of substrates and provided in respective subpixels of the plurality of subpixels;
a plurality of data lines (DL, DL1, DL2, DL3, DL4) each extending in a column direction between respective subpixels of the plurality of subpixels and each being configured to transmit a respective data voltage to at least one respective subpixel of the plurality of subpixels; and
a plurality of light-emitting elements (OLED), each of the plurality of light-emitting elements being disposed in a respective subpixel of the plurality of subpixels and each being electrically connected to at least one transistor of the plurality of transistors,
wherein the substrates of the plurality of substrates are disposed spaced apart from one another, and
wherein the plurality of data lines is disposed in a region in which the substrates are spaced apart from one another,
**characterised in that**, the display device further comprising a light-blocking layer (LS) disposed on the plurality of substrates so as to overlap the plurality of transistors,
wherein the light-blocking layer is connected to a source electrode (SE1, SE2, SE3) or a drain electrode (DE1, DE2, DE3) of the plurality of transistors, and the plurality of substrates is connected to the light-blocking layer.

2. The display device (100, 600, 700, 800, 900, 1000) of claim 1, wherein the plurality of substrates (110, 710, 910) extends in a column direction.

3. The display device (100, 600, 700, 800, 900, 1000) of claim 1 or claim 2, further comprising:
a storage capacitor (SC) comprising:
a fourth capacitor electrode (SC4), wherein the fourth capacitor electrode is the plurality of substrates;
a first capacitor electrode (SC1) made of the same material as the light-blocking layer (LS); and
a second capacitor electrode (SC2) made of the same material as an active layer (ACT1, ACT2, ACT3) of
the plurality of transistors,
wherein the fourth capacitor electrode and the second capacitor electrode are connected to each other.

4. The display device (100, 600, 700, 800, 900, 1000) of claim 3, wherein the storage capacitor (SC) further comprises a third capacitor electrode (SC3) made of the same material as an anode (AN) of the plurality of light-emitting elements (OLED) or made of the same material as a gate electrode (GE1, GE2, GE3) of the plurality of transistors (TR1, TR2, TR3).

5. The display device (100, 600, 700, 800, 900, 1000) of any preceding claim, wherein the substrates (110, 710, 910) of the plurality of substrates are spaced apart from one another so as to correspond to the plurality of subpixels (SP, SPR, SPW, SPB, SPG), respectively.

6. The display device (100, 600, 700, 800, 900, 1000) of claim 1, wherein the plurality of transistors (TR1, TR2, TR3) is a driving transistor.

7. The display device (100, 600, 700, 800, 900, 1000) of claim 1 or claim 6, wherein the plurality of substrates (110, 710, 910) is arranged in a matrix shape so as to correspond to the plurality of subpixels (SP, SPR, SPW, SPB, SPG), respectively.

8. The display device (100, 600, 700, 800, 900, 1000) of any preceding claim, further comprising:
a plurality of reference lines (RL) each extending in a column direction between respective subpixels (SP, SPR, SPW, SPB, SPG) of the plurality of subpixels and each being configured to transmit a respective reference voltage to at least one respective subpixel of the plurality of subpixels,
wherein the plurality of reference lines is disposed in the region in which the substrates (110, 710, 910) are spaced apart from one another.

9. The display device (100, 600, 700, 800, 900, 1000) of claim 8, wherein each substrate (110, 710, 910) of the plurality of substrates comprises a respective rim facing and parallel to at least one respective data line (DL, DL1, DL2, DL3, DL4) of the plurality of data lines and at least one respective reference line (RL) of the plurality of reference lines.

## Patentansprüche

1. Anzeigevorrichtung (100, 600, 700, 800, 900, 1000), umfassend:
eine Vielzahl von Substraten (110, 710, 910), wobei jedes aus der Vielzahl von Substraten in einem entsprechenden Subpixel (SP, SPR, SPW, SPB, SPG) aus einer Vielzahl von Subpixeln angebracht ist und eine von einer transparenten leitenden Oxidschicht oder einer Oxid-Halbleiterschicht umfasst;
eine Vielzahl von Transistoren (TR1, TR2, TR3) die auf entsprechenden Substraten aus der Vielzahl von Substraten angebracht sind und in entsprechenden Subpixeln aus der Vielzahl von Subpixeln bereitgestellt werden;
eine Vielzahl von Datenleitungen (DL, DL1, DL2, DL3, DL4), die sich jeweils in einer Spaltenrichtung zwischen entsprechenden Subpixeln aus der Vielzahl von Subpixeln erstrecken und die jeweils konfiguriert sind zum Übertragen einer entsprechenden Datenspannung zu mindestens einem entsprechenden Subpixel aus der Vielzahl von Subpixeln; und
eine Vielzahl von lichtemittierenden Elementen (OLEDs), wobei jedes aus der Vielzahl von lichtemittierenden Elementen in einem entsprechenden Subpixel aus der Vielzahl von Subpixeln angebracht ist, und wobei jedes mit mindestens einem Transistor aus der Vielzahl von Transistoren elektrisch verbunden ist,
wobei die Substrate aus der Vielzahl von Substraten voneinander beabstandet angebracht sind, und
wobei die Vielzahl von Datenleitungen in einem Gebiet angebracht sind, in dem die Substrate voneinander beabstandet sind,
**dadurch gekennzeichnet, dass** die Anzeigevorrichtung ferner eine lichtundurchlässige Schicht (LS) umfasst, die auf der Vielzahl von Substraten angebracht ist, um die Vielzahl von Transistoren zu überlagern,
wobei die lichtundurchlässige Schicht mit einer Source-Elektrode (SE1, SE2, SE3) oder einer Drain-Elektrode (DE1, DE2, DE3) der Vielzahl von Transistoren verbunden ist, und wobei die Vielzahl von Substraten mit der lichtundurchlässigen Schicht verbunden ist.

2. Anzeigevorrichtung (100, 600, 700, 800, 900, 1000) nach Anspruch 1, wobei sich die Vielzahl von Substraten (110, 710, 910) in einer Spaltenrichtung erstreckt.

3. Anzeigevorrichtung (100, 600, 700, 800, 900, 1000) nach Anspruch 1 oder Anspruch 2, die ferner umfasst:
einen Speicherkondensator (SC) der umfasst:
eine vierte Kondensatorelektrode (SC4), wobei die vierte Kondensatorelektrode die Vielzahl von Substraten ist;
eine erste Kondensatorelektrode (SC1), die aus dem gleichen Material wie die lichtundurchlässige Schicht (LS) gefertigt ist; und
eine zweite Kondensatorelektrode (SC2), die aus dem gleichen Material wie eine aktive Schicht (ACT1, ACT2, ACT3) der Vielzahl von Transistoren gefertigt ist,
wobei die vierte Kondensatorelektrode und die zweite Kondensatorelektrode miteinander verbunden sind.

4. Anzeigevorrichtung (100, 600, 700, 800, 900, 1000) nach Anspruch 3, wobei der Speicherkondensator (SC) ferner eine dritte Kondensatorelektrode (SC3) umfasst, die aus dem gleichen Material wie eine Anode (AN) der Vielzahl von lichtemittierenden Elementen (OLEDs) gefertigt ist, oder die aus dem gleichen Material wie eine Gate-Elektrode (GE1, GE2, GE3) der Vielzahl von Transistoren (TR1, TR2, TR3) gefertigt ist.

5. Anzeigevorrichtung (100, 600, 700, 800, 900, 1000) nach einem der vorhergehenden Ansprüche, wobei die Substrate (110, 710, 910) aus der Vielzahl von Substraten voneinander beabstandet sind, um jeweils der Vielzahl von Subpixeln (SP, SPR, SPW, SPB, SPG) zu entsprechen.

6. Anzeigevorrichtung (100, 600, 700, 800, 900, 1000) nach Anspruch 1, wobei die Vielzahl von Transistoren (TR1, TR2, TR3) ein Ansteuerungstransistor ist.

7. Anzeigevorrichtung (100, 600, 700, 800, 900, 1000) nach Anspruch 1 oder Anspruch 6, wobei die Vielzahl von Substraten (110, 710, 910) in einer Matrixform angeordnet sind, um jeweils der Vielzahl von Subpixeln (SP, SPR, SPW, SPB, SPG) zu entsprechen.

8. Anzeigevorrichtung (100, 600, 700, 800, 900, 1000) nach einem der vorhergehenden Ansprüche, die ferner umfasst:
eine Vielzahl von Referenzleitungen (RL), die sich jeweils in einer Spaltenrichtung zwischen entsprechenden Subpixeln (SP, SPR, SPW, SPB, SPG) aus der Vielzahl von Subpixeln erstrecken und die jeweils konfiguriert sind zum Übertragen einer entsprechenden Referenzspannung zu mindestens einem entsprechenden Subpixel aus der Vielzahl von Subpixeln,
wobei die Vielzahl von Referenzleitungen in dem Gebiet angebracht sind, in dem die Substrate (110, 710, 910) voneinander beabstandet sind.

9. Anzeigevorrichtung (100, 600, 700, 800, 900, 1000) nach Anspruch 8, wobei jedes Substrat (110, 710, 910) aus der Vielzahl von Substraten einen entsprechenden Flansch umfasst, der mindestens einer entsprechenden Datenleitung (DL, DL1, DL2, DL3, DL4) aus der Vielzahl von Datenleitungen und mindestens einer entsprechenden Referenzleitung (RL) aus der Vielzahl von Referenzleitungen zugewandt ist und parallel zu diesen ist.

## Revendications

1. Dispositif d'affichage (100, 600, 700, 800, 900, 1000) comprenant :
une pluralité de substrats (110, 710, 910), chaque substrat de la pluralité de substrats étant disposé dans un sous-pixel respectif (SP, SPR, SPW, SPB, SPG) d'une pluralité de sous-pixels et comprenant soit une couche d'oxyde conducteur transparent, soit une couche de semiconducteur à base d'oxyde ;
une pluralité de transistors (TR1, TR2, TR3) disposés sur des substrats respectifs de la pluralité de substrats et placés dans des sous-pixels respectifs de la pluralité de sous-pixels ;
une pluralité de lignes de données (DL, DL1, DL2, DL3, DL4), chacune s'étendant dans une direction de colonne entre des sous-pixels respectifs de la pluralité de sous-pixels et chacune étant conçue pour transmettre une tension de données respective à au moins un sous-pixel respectif de la pluralité de sous-pixels ; et
une pluralité d'éléments émetteurs de lumière (OLED), chaque élément de la pluralité d'éléments émetteurs de lumière étant disposé dans un sous-pixel respectif de la pluralité de sous-pixels, et chacun étant relié électriquement à au moins un transistor de la pluralité de transistors,
dans lequel les substrats de la pluralité de substrats sont disposés espacés les uns des autres, et
dans lequel la pluralité de lignes de données est disposée dans une région dans laquelle les substrats sont espacés les uns des autres,
**caractérisé en ce que**
le dispositif d'affichage comprend en outre une couche bloquant la lumière (LS) disposée sur la pluralité de substrats de manière à chevaucher la pluralité de transistors,
dans lequel la couche bloquant la lumière est reliée à une électrode de source (SE1, SE2, SE3) ou une électrode de drain (DE1, DE2, DE3) de la pluralité de transistors, et la pluralité de substrats est reliée à la couche bloquant la lumière.

2. Dispositif d'affichage (100, 600, 700, 800, 900, 1000) de la revendication 1, dans lequel la pluralité de substrats (110, 710, 910) s'étend dans une direction de colonne.

3. Dispositif d'affichage (100, 600, 700, 800, 900, 1000) de la revendication 1 ou la revendication 2, comprenant en outre :
un condensateur de stockage (SC) comprenant :
une quatrième électrode de condensateur (SC4), la quatrième électrode de condensateur étant la pluralité de substrats ;
une première électrode de condensateur (SC1) constituée du même matériau que la couche bloquant la lumière (LS) ; et
une deuxième électrode de condensateur (SC2) constituée du même matériau qu'une couche active (ACT1, ACT2, ACT3) de la pluralité de transistors,
dans lequel la quatrième électrode de condensateur et la deuxième électrode de condensateur sont reliées l'une à l'autre.

4. Dispositif d'affichage (100, 600, 700, 800, 900, 1000) de la revendication 3, dans lequel le condensateur de stockage (SC) comprend en outre une troisième électrode de condensateur (SC3) constituée du même matériau qu'une anode (AN) de la pluralité d'éléments émetteurs de lumière (OLED) ou constituée du même matériau qu'une électrode de grille (GE1, GE2, GE3) de la pluralité de transistors (TR1, TR2, TR3).

5. Dispositif d'affichage (100, 600, 700, 800, 900, 1000) d'une quelconque revendication précédente, dans lequel les substrats (110, 710, 910) de la pluralité de substrats sont espacés les uns des autres de manière à respectivement correspondre à la pluralité de sous-pixels (SP, SPR, SPW, SPB, SPG).

6. Dispositif d'affichage (100, 600, 700, 800, 900, 1000) de la revendication 1, dans lequel la pluralité de transistors (TR1, TR2, TR3) est un transistor de commande.

7. Dispositif d'affichage (100, 600, 700, 800, 900, 1000) de la revendication 1 ou la revendication 6, dans lequel la pluralité de substrats (110, 710, 910) est agencée sous la forme d'une matrice de manière à respectivement correspondre à la pluralité de sous-pixels (SP, SPR, SPW, SPB, SPG).

8. Dispositif d'affichage (100, 600, 700, 800, 900, 1000) d'une quelconque revendication précédente, comprenant en outre :
une pluralité de lignes de référence (RL), chacune s'étendant dans une direction de colonne entre des sous-pixels respectifs (SP, SPR, SPW, SPB, SPG) de la pluralité de sous-pixels et chacune étant conçue pour transmettre une tension de référence respective à au moins un sous-pixel respectif de la pluralité de sous-pixels,
dans lequel la pluralité de lignes de référence est disposée dans la région dans laquelle les substrats (110, 710, 910) sont espacés les uns des autres.

9. Dispositif d'affichage (100, 600, 700, 800, 900, 1000) de la revendication 8, dans lequel chaque substrat (110, 710, 910) de la pluralité de substrats comprend un bord respectif faisant face et parallèle à au moins une ligne de données respective (DL, DL1, DL2, DL3, DL4) de la pluralité de lignes de données et au moins une ligne de référence respective (RL) de la pluralité de lignes de référence.
